# EUROPEAN PATENT SPECIFICATION

(11) **EP 2 839 968 B1**
(45) Date of publication and mention of the grant of the patent: **11.07.2018**
(21) Application number: 13767386.9
(22) Date of filing: 20.02.2013
(51) Int. Cl.: B41N 1/14, G03F 7/00, G03F 7/004, G03F 7/038, G03F 7/11, B41C 1/10, C09D 11/106, G03F 7/031, G03F 7/09, G03F 7/105

(54) **ORIGINAL PLATE FOR LITHOGRAPHIC PRINTING PLATE, AND METHOD FOR PRINTING SAME**
ORIGINALPLATTE FÜR EINE LITHOGRAPHISCHE DRUCKPLATTE UND DRUCKVERFAHREN DAFÜR
PLAQUE ORIGINALE POUR PLAQUE D'IMPRESSION LITHOGRAPHIQUE, ET SON PROCÉDÉ D'IMPRESSION

(30) Priority: 29.03.2012 JP 2012078095
(43) Date of publication of application: 25.02.2015
(73) Proprietor: FUJIFILM Corporation, Tokyo 106-0031 (JP)
(72) Inventor: SHIRAKI Fumiya, Haibara-gun Shizuoka 421-0396 (JP); INNO Toshifumi, Haibara-gun Shizuoka 421-0396 (JP); MIYAGAWA Yuuya, Haibara-gun Shizuoka 421-0396 (JP)
(74) Representative: Hoffmann Eitle
(86) International application number: PCT/JP2013/054155
(87) International publication number: WO 2013/145949

(56) References cited:
- EP-A2- 1 557 262
- EP-A2- 1 614 541
- GB-A- 2 062 885
- JP-A- 2004 101 892
- JP-A- 2005 262 708
- JP-A- 2005 349 745
- JP-A- 2006 007 699
- JP-A- 2006 035 459
- JP-A- 2006 035 459
- JP-A- 2007 203 715

## Description

### TECHNICAL FIELD

The present invention relates to a lithographic printing plate precursor of on-press development type and a printing method thereof. More particularly, it relates to a lithographic printing plate precursor which is excellent in visibility of visible image after exposure and a printing method thereof.

### BACKGROUND ART

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-forming layer) is heretofore used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

As simplification of the plate making progresses, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.

Also, as another issue on the lithographic printing plate precursor, an environmental problem on waste liquid discharged accompanying the wet treatment, for example, development processing comes to the front, and simplification of development or plate making or non-processing has been pursued.

As one method of simple plate making, a method referred to as an "on-press development" is practiced. Specifically, according to the method after exposure of a lithographic printing plate precursor, the lithographic printing plate precursor is mounted as it is on a printing machine without undergoing conventional development, and removal of the unnecessary area of image-forming layer is performed at an early stage of usual printing process.

In the simplification of plate making operation as described above, a system using a lithographic printing plate precursor capable of being handled in a bright room and a light source is preferred from the standpoint of workability. Thus, as the light source, a semiconductor laser emitting an infrared ray having a wavelength of 760 to 1,200 or a solid laser, for example, YAG laser, is used.

As the lithographic printing plate capable of undergoing on-press development, for instance, a lithographic printing plate precursor having provided on a hydrophilic support, an image-forming layer (heat-sensitive layer) containing microcapsules having a polymerizable compound encapsulated therein is described in Patent Documents 1 and 2. A lithographic printing plate precursor having provided on a support, an image-recording layer (photosensitive layer) containing an infrared absorbing dye, a radical polymerization initiator and a polymerizable compound is described in Patent Document 3. A lithographic printing plate precursor capable of undergoing on-press development having provided on a support, an image-recording layer containing a polymerizable compound and a graft polymer having a polyethylene oxide chain in its side chain or a block polymer having a polyethylene oxide block is described in Patent Document 4.

In general, an operation (plate inspection) for inspection and discrimination of image formed on a printing plate is carried out in order to examine whether the image is recorded on the printing plate as intended, in advance of mounting the printing plate on a printing machine. In a conventional lithographic printing plate precursor subjected to a development processing step, since a color image is ordinarily obtained due to the development processing by means of coloration of the image-recording layer, it is easily performed to confirm the image formed before the mounting the printing plate on a printing machine.

However, with respect to the lithographic printing plate precursor of the on-press development type or non-processing (non-development) type without accompanying the development processing, the image is not recognized on the printing plate in the step of mounting it on a printing machine, and thus the plate inspection cannot be performed. In particular, it is vital in the printing operation to determine whether a registry guide (register mark) which acts as a landmark for the register in multicolor printing is recorded. Therefore, in the lithographic printing plate precursor of the on-press development type or non-processing (non-development) type, a means for confirming the image, that is, color formation or decoloration in the exposed area to form a so-called print-out image is required at the stage after exposure.

A lithographic printing plate precursor is proposed wherein a compound capable of generating an acid, a base or a radical by means of light or heat and a compound capable of undergoing color change upon interaction with the acid, the base or the radical generated are used as a print-out agent (for example, see Patent Document 5). Also, it is proposed to utilize color change of thermally decomposable compound as the print-out agent of a direct-drawing type lithographic printing plate precursor having a heat-sensitive layer (for example, see Patent Document 6). Further, it is proposed to use a thermally decomposable dye having a thermally decomposable temperature of 250°C or below as the print-out agent (for example, see Patent Document 7).

According to these proposals, although the color formation or decoloration occurs in the exposed area and the plate inspection property increases to some extent, it is still insufficient.

It is described in Patent Document 8 that a print-out image having a good visibility and a level capable of performing plate inspection is obtained by a system containing an infrared absorbing agent of cyanine dye having a 5-membered ring in its methine chain and a radical generator. However, further improvement has been requested from a practical standpoint.

### PRIOR ART DOCUMENT

### PATENT DOCUMENT

Patent Document 1: JP-A-2001-277740
Patent Document 2: JP-A-2001-277742
Patent Document 3: JP-A-2002-287334
Patent Document 4: U.S. Patent Publication No. 2003/0064318
Patent Document 5: JP-A-11-277927
Patent Document 6: JP-A-2000-335129
Patent Document 7: JP-A-2003-191657
Patent Document 8: JP-A-2007-90850

Patent document EP 1 557 262 A2 discloses a lithographic printing plate precursor and a lithographic printing method using the same.

### DISCLOSURE OF THE INVENTION

### PROBLEMS THAT THE INVENTION IS TO SOLVE

An object of the invention is to provide a lithographic printing plate precursor capable of undergoing on-press development which is excellent in visibility of visible image after exposure and a printing method thereof.

### MEANS FOR SOLVING THE PROBLEMS

(1) A lithographic printing plate precursor having at least a white substrate and an image-recording layer, wherein the white substrate has a reflection density of 0.25 or less at a side having the image-recording layer, and the image-recording layer contains an infrared absorbing agent, an onium salt polymerization initiator, a polymerizable compound and a color-forming compound and is capable of being removed with at least any one of printing ink and dampening water.
(2) The lithographic printing plate precursor as described in (1), wherein the white substrate has a white layer on an aluminum support.
(3) The lithographic printing plate precursor as described in (2), wherein the white layer contains at least any one of a fluorescent whitening agent and a white pigment.
(4) The lithographic printing plate precursor as described in (3), wherein the white layer contains a fluorescent whitening agent.
(5) The lithographic printing plate precursor as described in (4), wherein the fluorescent whitening agent is a stilbene compound.
(6) The lithographic printing plate precursor as described in any one of (2) to (5), wherein the white layer contains an inorganic hydrophilic matrix.
(7) The lithographic printing plate precursor as described in any one of (2) to (6), wherein the white layer contains a polymer having a repeating unit containing at least one ethylenically unsaturated bond and a repeating unit containing at least one functional group capable of interacting with a surface of the aluminum support.
(8) The lithographic printing plate precursor as described in (1), wherein the white substrate is an aluminum support which is subjected to a roughening treatment and an anodizing treatment so as to have a steepness degree a45 of 30% or less, wherein a45 represents an area ratio of a portion having an inclination of 45° or more obtained by extracting components having a wavelength from 0.2 to 2 µm.
(9) The lithographic printing plate precursor as described in (8), wherein between the aluminum support which is subjected to a roughening treatment and an anodizing treatment so as to have a steepness degree a45 of 30% or less and the image-recording layer, a polymer having a repeating unit containing at least one ethylenically unsaturated bond and a repeating unit containing at least one functional group capable of interacting with a surface of the aluminum support is contained.
(10) The lithographic printing plate precursor as described in any one of (1) to (9), wherein the color-forming compound is a cyanine dye represented by formula (1) shown below: 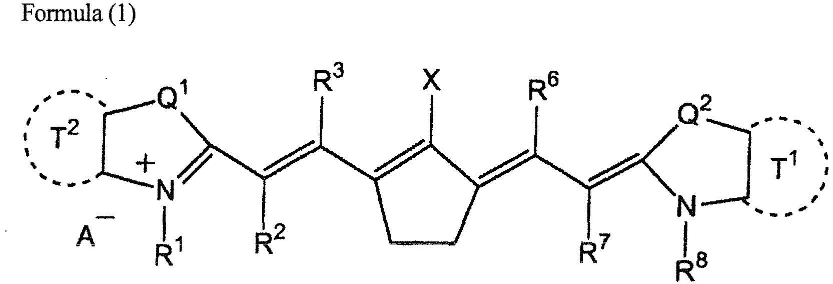
   In the formula, R¹ and R⁸ each independently represents a monovalent substituent, R², R³, R⁶ and R⁷ each independently represents a hydrogen atom or a hydrocarbon group, X represents -NPh₂, Q¹ and Q² each independently represents -NR⁹-, a sulfur atom, an oxygen atom or a dialkylmethylene group, R⁹ represents a hydrogen atom or a hydrocarbon group which may have a substituent, T¹ and T² each independently represents an aromatic ring or a heteroaromatic ring, and A⁻ represents an anion.
(11) The lithographic printing plate precursor as described in any one of (1) to (10), wherein the onium salt polymerization initiator is an iodonium salt or a sulfonium salt.
(12) The lithographic printing plate precursor as described in any one of (1) to (11), wherein the color-forming compound is an acid color-forming agent.
(13) The lithographic printing plate precursor as described in any one of (1) to (12), wherein the color-forming compound is a heat color-forming agent.
(14) The lithographic printing plate precursor as described in (12) or (13), wherein the image-recording layer contains a borate compound.
(15) The lithographic printing plate precursor as described in (14), wherein the borate compound is a tetraphenyl borate.
(16) A printing method of a lithographic printing plate comprising exposing imagewise the lithographic printing plate precursor as described in any one of (1) to (15) with an infrared laser, mounting the exposed lithographic printing plate precursor on a printing machine, and removing an unexposed area of the image-recording layer by supplying printing ink and dampening water to perform printing.

### ADVANTAGE OF THE INVENTION

According to the invention, a lithographic printing plate precursor capable of undergoing on-press development which is excellent in visibility of visible image after exposure and a printing method thereof can be provided.

### MODE FOR CARRYING OUT THE INVENTION

### [Lithographic printing plate precursor]

The lithographic printing plate precursor according to the invention is a lithographic printing plate precursor having at least a white substrate and an image-recording layer (also referred to as an image-forming layer), wherein the white substrate has a reflection density of 0.25 or less at a side having the image-recording layer, and the image-recording layer contains an infrared absorbing agent, an onium salt polymerization initiator, a polymerizable compound and a color-forming compound and is capable of being removed with at least any one of printing ink and dampening water. The lithographic printing plate precursor according to the invention may have a protective layer on the image-recording layer. Also, the lithographic printing plate precursor according to the invention may have an undercoat layer between an aluminum support and the image-recording layer.

The lithographic printing plate precursor according to the invention preferably has a reflection density of 0.53 or less from a side having the image-recording layer. It is more preferred that the image-recording layer does not contain a coloring agent or the content of the coloring agent is 2.5% by weight or less, in order to achieve good visibility of the colored image after exposure.

The reflection density as used herein means an optical density (Optical Density) and is a value represented by O.D.=Log₁₀(I₀/I), wherein I₀ is an intensity of incident light to a reflecting surface and I is an intensity of reflected light from the reflecting surface. The reflection density described in the invention is a value measured using Macbeth reflection densitometer Model RD918 (produced by Gretag Macbeth Co., Ltd.) in a black and white mode.

### <White substrate>

The white substrate according to the invention means a substrate having a surface having a reflection density of 0.25 or less. One specific example of the white substrate is (1) a substrate having a white layer provided on an aluminum support. In this case, the image-recording layer is formed on the white layer. Another example of the white substrate is (2) an aluminum support which is subjected to a roughening treatment and an anodizing treatment so as to have a steepness degree a45 of 30% or less. In this case, the image-recording layer may be formed on the aluminum support without a white layer or may be formed on an undercoat layer which has been provided on the aluminum support. Also, the image-recording layer may be formed on a white layer which has been provided on the aluminum support. The reflection density value of the white substrate is preferably from 0.01 to 0.25, more preferably from 0.01 to 0.20, and most preferably from 0.01 to 0.15. In the case where the reflection density exceeds 0.25, since the unexposed area is colored, even when a print-out image is formed in the exposed region, the color change between the unexposed area and the exposed area is small to cause a problem in that good image visibility is not obtained.

The steepness degree a45 is one of the factors indicating a surface configuration and a value obtained in the following manner.

### (1) To obtain a three-dimensional data by measurement of surface configuration.

First, the surface configuration is measured by an atomic forth microscope (Atomic Forth Microscope: AFM) to obtain a three-dimensional data.

The measurement can be performed, for example, under the conditions described below. Specifically, the support cut into a size of 1 cm square and set on a horizontal sample table placed on a piezoscanner. A cantilever is approached the surface of the sample, when the cantilever reaches the region of acting an atomic force, the sample surface is scanned in the XY directions, and in this case, the unevenness of the sample is caught as the displacement of the piezoscanner in the Z direction. The piezoscanner capable of scanning 150 µm in the XY directions and 10 µm in the Z direction is used. The cantilever (SI-DF20, produced by NANOPROBE Co.) having a resonance frequency of 120 to 150 kHz and a spring constant of 12 to 20 N/m is used, and the measurement is performed in a DFM mode (Dynamic Force Mode). A slight inclination of the sample is corrected by approximating the three-dimensional data obtained by a least square method to determine a datum level.

For the measurement, 512 x 512 points on the surface of 50 x 50 µm are measured. Resolution in the XY directions is set to 1.9 µm, resolution in the Z direction is set to 1 nm, and a scanning speed is set to 60 µm/sec.

### (2) To perform correction.

For the calculation of the a45, a corrected value obtained by eliminating the components of a wavelength from 0.2 to 2 µm from the three-dimensional data obtained by formula (1) above is used. Due to the correction, in the case of scanning with a probe of AFM on the surface having deep unevennesses such as a support used for lithographic printing plate precursor, noises generated when the probe hits an edge part of the convex portion to bound or when a part other than the probe contacts to a wall surface of the deep concave portion can be removed.

The correction is performed by subjecting the three-dimensional data obtained by formula (1) to fast Fourier transformation to obtain a frequency distribution, removing the components a wavelength from 0.2 to 2 µm therefrom, and conducting inverse Fourier transformation.

### (3) To calculate a45.

Three points adjacent to each other are extracted from the three-dimensional data (f(x, y)) obtained by the correction in (2) above, all data on the angles formed between the small triangle formed by the three points and the datum level are calculated to obtain an inclination distribution curve. On the other hand, the sum of the areas of the small triangles is determined to be an actual area. From the inclination distribution curve, the a45 (unit: %) which is a ratio of the total area of the portions having the inclination of 45 degree or more to the actual area is calculated.

### <White layer>

The white layer according to the invention preferably contains at least any one of a fluorescent whitening agent and a white pigment. Of the white layers, the white layer containing a fluorescent whitening agent is preferred. The white layer may contain both of the fluorescent whitening agent and the white pigment.

Also, the white layer preferably contains an inorganic hydrophilic matrix. Further, the white layer may contain a polymer having a repeating unit containing at least one ethylenically unsaturated bond and a repeating unit containing at least one functional group capable of interacting with a surface of the aluminum support.

### (Fluorescent whitening agent)

In general, the fluorescent whitening agent is composed of a compound having a property of absorbing light having a wavelength from about 320 to about 410 nm and emitting light having a wavelength from about 410 to about 500 nm. It is known that as to fabric dyed with such a fluorescent whitening agent, since blue light having a wavelength from about 410 to about 500 nm emitted from the fluorescent whitening agent is newly added to the original yellow reflection light, the reflection light becomes white, and the energy of visible light increases in an amount based on the fluorescent effect and as a result, the fabric dyed itself is seemed to be visually increased in whiteness, thereby carrying out whitening. As a result of the investigations, the inventors have found that the same effect is also achieved in the lithographic printing plate precursor containing a fluorescent whitening agent.

The fluorescent whitening agent for use in the invention includes, for example, compounds described in Goseisikiso no Kagaku (The Chemistry of Synthetic dyes), Vol. V, Chapter 8, edited by K. Veen-Rataramann. More specifically, it includes a stilbene compound, a biphenyl compound, a coumarin compound, an imidazole compound, a benzoxazolyl compound, a naphthalimide compound, a pyrazoline compound and a carbostyryl compound.

Of the fluorescent whitening agents, a stilbene compound is preferred as the fluorescent whitening agent for use in the invention, and a water-soluble diaminostilbene compound is particularly preferred. The diaminostilbene compound having a sulfo group as the water-soluble group is more preferred.

Examples of compound of the fluorescent whitening agent preferably used in the invention are set forth below, but the invention should not be construed as being limited thereto.

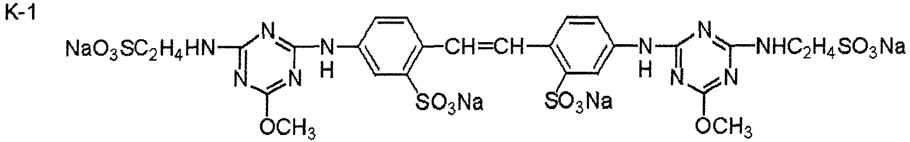

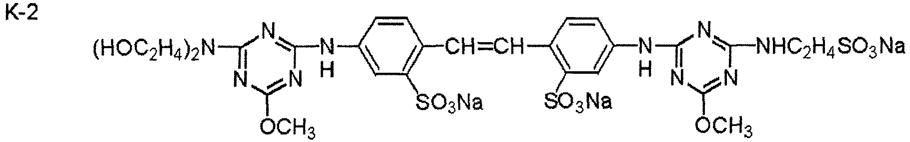

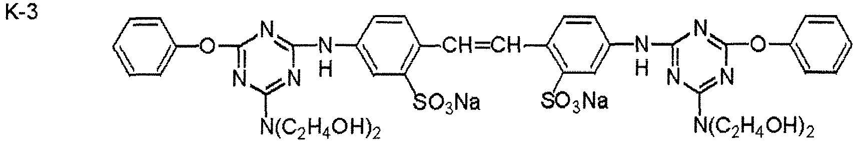

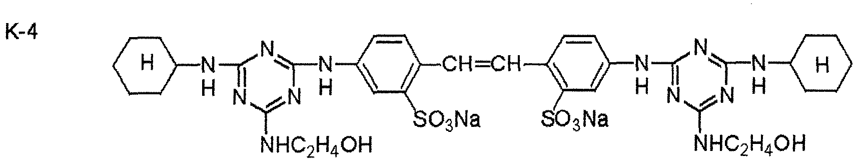

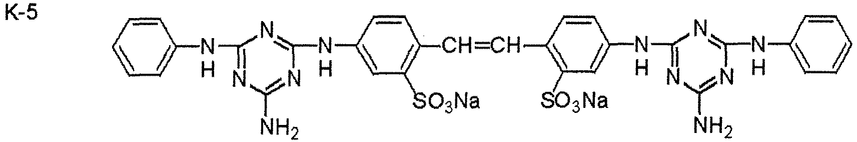

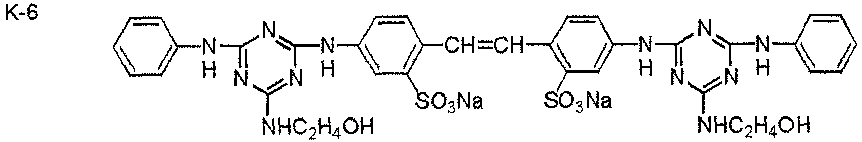

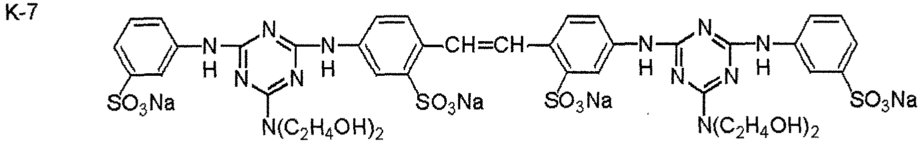

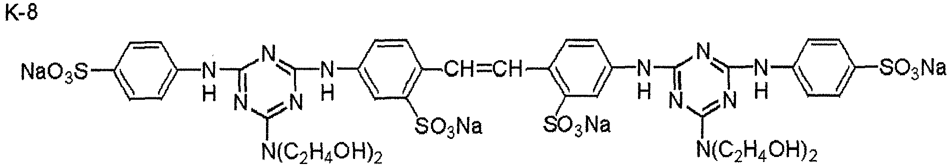

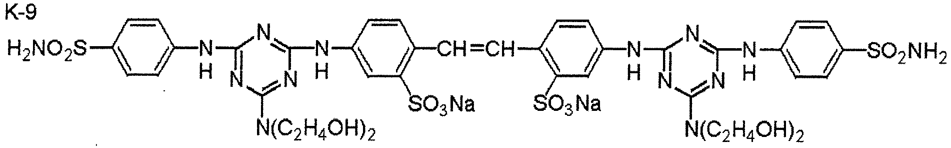

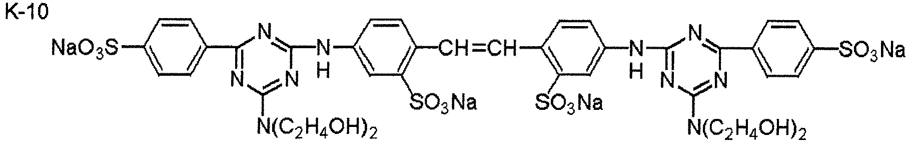

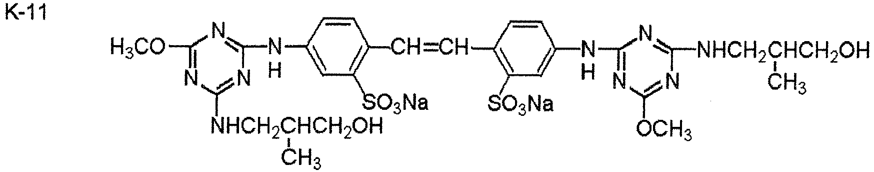

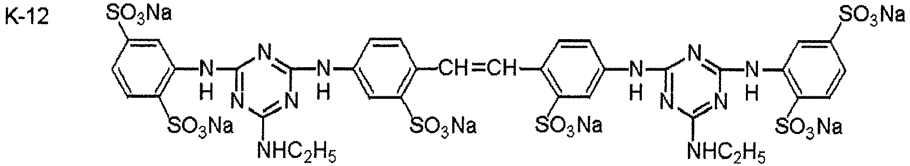

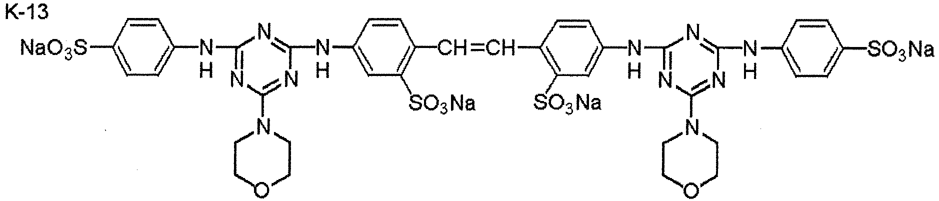

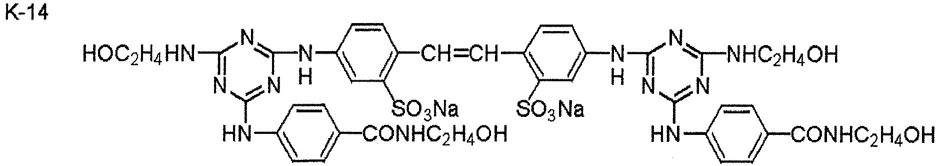

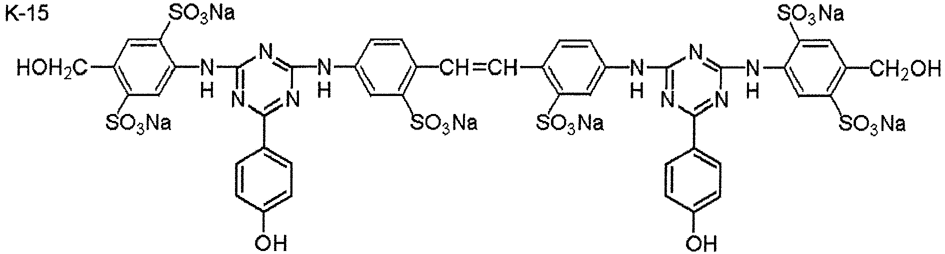

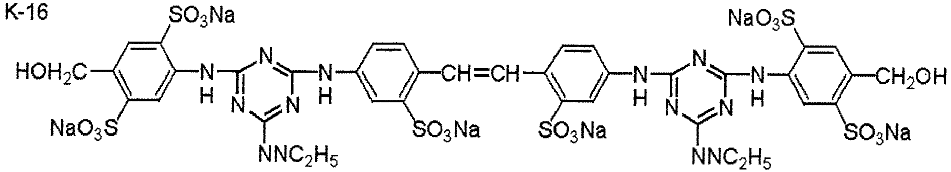

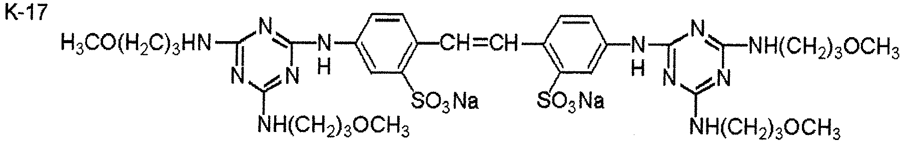

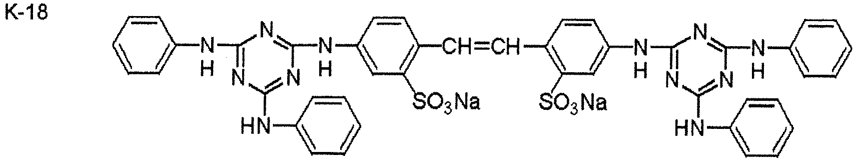

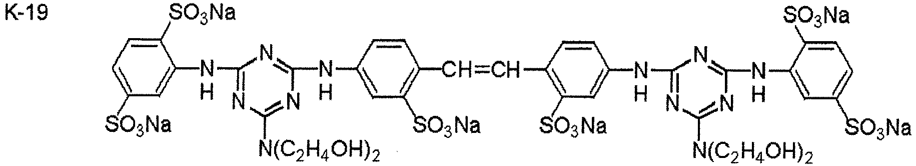

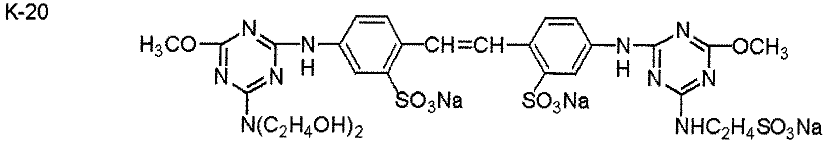

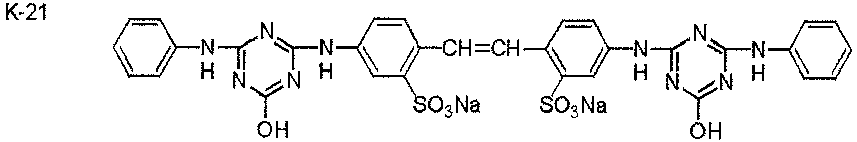

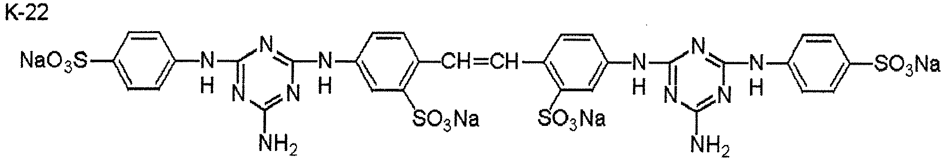

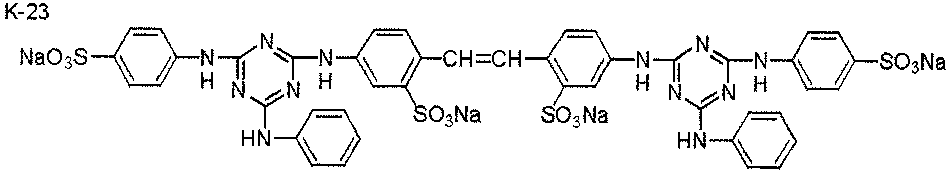

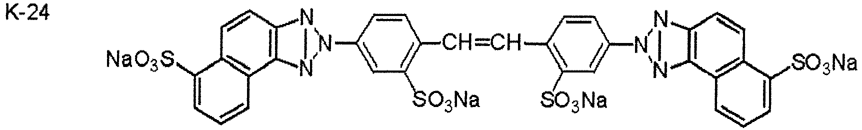

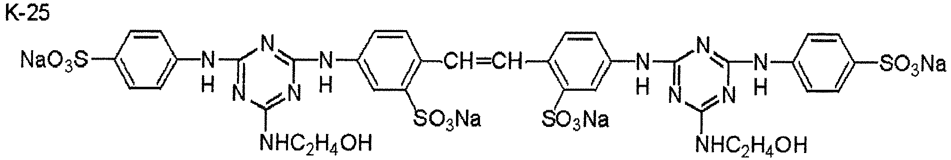

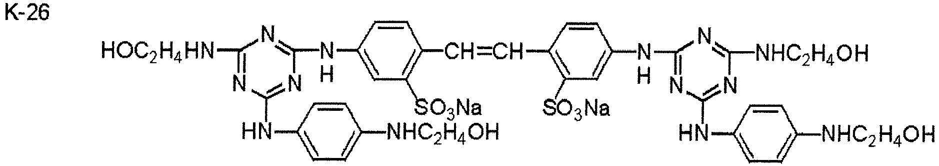

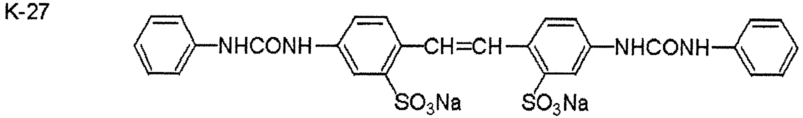

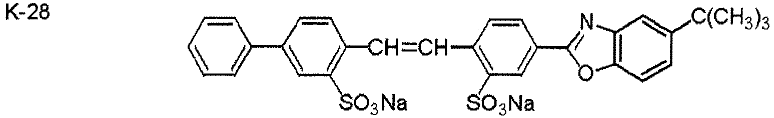

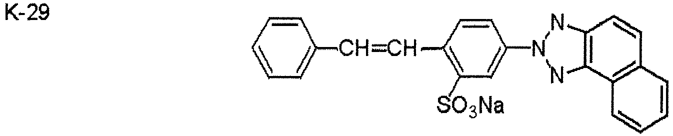

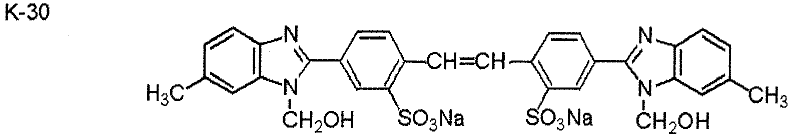

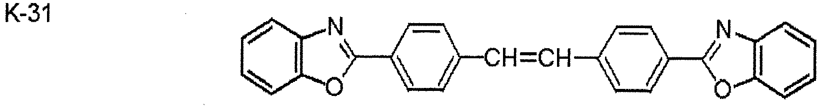

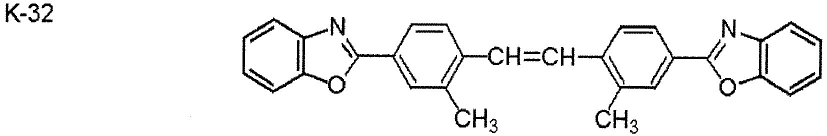

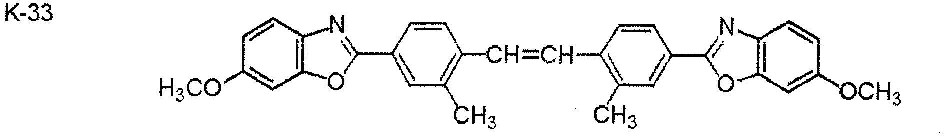

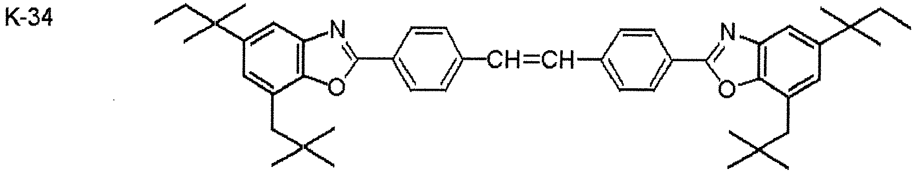

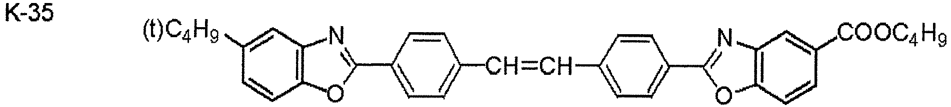

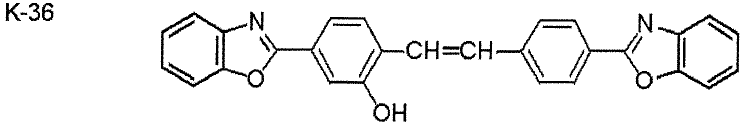

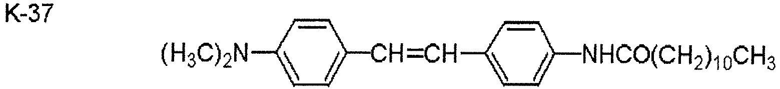

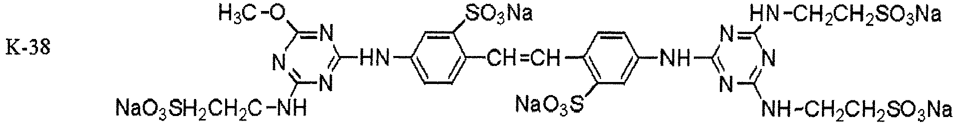

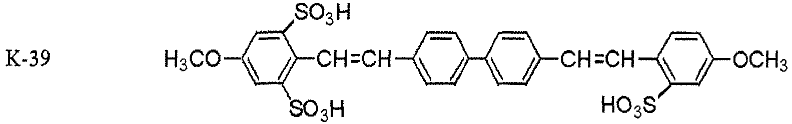

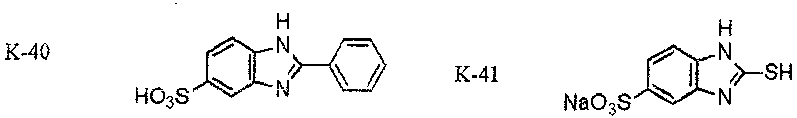

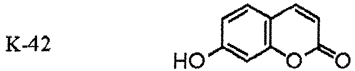

The content of the fluorescent whitening agent in the white layer is preferably from 0.05 to 0.2 g/m², and more preferably from 0.07 to 0.15 g/m². In the range described above, good reflection density is obtained, and good visibility of the print-out image is obtained.

### (White pigment)

The white pigment used in the white layer according to the invention includes, for example, titanium oxide, silica, zinc oxide, barium sulfate, calcium carbonate, fine powder of silicon, lead white, kaolin clay, wollastonite, potassium titanate and barium titanate, but the invention should not be construed as being limited thereto. Titanium oxide is preferably used as the white pigment. The particle size of the white pigment is preferably from 0.01 to 0.5 µm.

The amount of the white pigment added to the white layer is preferably from 0.05 to 0.3 g/m², more preferably from 0.10 to 0.20 g/m², and most preferably from 0.12 to 0.18 g/m². In the range described above, good reflection density is obtained, and good visibility of the print-out image is obtained.

### (Inorganic hydrophilic matrix)

The white layer according to the invention preferably contains an inorganic hydrophilic matrix. A system capable of conducting sol-gel conversion which can be used for forming the inorganic hydrophilic matrix is a polymer in which bonding groups of polyvalent element form a network structure through oxygen atoms, a polyvalent metal simultaneously has a non-bonded hydroxy group and an alkoxy group, and these are present in a mixed manner to form a resin structure, and which is in a sol state in the stage where the amount of the alkoxy group and the hydroxy group is large, and the network resinous structure becomes firm with the progress of formation of ether bonds. The system also has such a function that a part of the hydroxy groups is bonded to solid fine particles to modify the surface of the solid fine particles, thereby changing the hydrophilicity. Examples of the polyvalent bonding element in the compound having the hydroxy group and the alkoxy group capable of conducting the sol-gel conversion include metal alkoxides selected from Si, Ti, Zr and Al, any of which may be used in the invention. A sol-gel conversion system including a siloxane bond which is most preferably used in the invention is described below. The sol-gel conversion using aluminum, titanium or zirconium can be effected by replacing the silicon in the description below by the respective elements.

Specifically, a system capable of conducting sol-gel conversion and containing a silane compound having at least one silanol group is particularly preferably used. The system utilizing the sol-gel conversion is further described below. The inorganic hydrophilic matrix formed by the sol-gel conversion is preferably a resin having a siloxane bond and a silanol group, which is formed in such a manner that when a coating solution which is a sol system containing a silane compound having at least one silanol group is coated, dried and aged, hydrolytic condensation of the silanol group proceeds to form a structure of a siloxane skeleton, thereby advancing gelation. The siloxane resin forming the gel structure is represented by formula (2) shown below, and the silane compound having at least one silanol group is obtained by hydrolysis of a silane compound represented by formula (3) shown below. The silane compound having at least one silanol group is not necessarily a partial hydrolysis product of the silane compound represented by formula (3) solely, and in general, may be composed of an oligomer formed by partial hydrolytic polymerization of the silane compound or a mixed composition of the silane compound and the oligomer thereof.

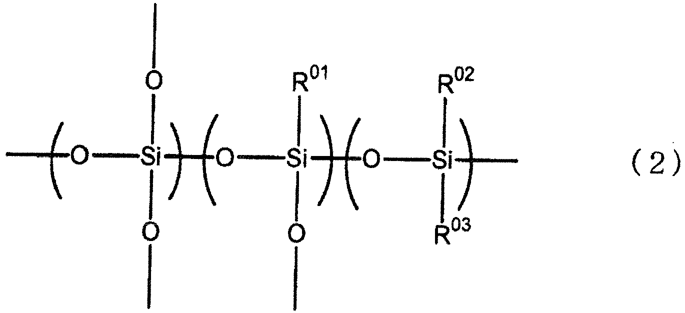

The siloxane resin represented by formula (2) is formed by the sol-gel conversion of at least one compound of the silane compound represented by formula (3), and in formula (2), at least one of R⁰¹ to R⁰³ represents a hydroxy group, and the others each represents an organic residue selected from R⁰ and Y in formula (3).

(R⁰)ₙSi(Y)₄₋ₙ (3)

In formula (3), R⁰ represents a hydroxy group, a hydrocarbon group or a heterocyclic group, Y represents a hydrogen atom, a halogen atom (for example, a fluorine atom, a chlorine atom, a bromine atom or an iodine atom), -OR¹, -OCOR² or -N(R³)(R⁴) (in which R¹ and R² each represents a hydrocarbon group, and R³ and R⁴, which may be the same or different, each represents a hydrogen atom or a hydrocarbon group), and n represents 0, 1, 2 or 3.

Examples of the hydrocarbon group or the heterocyclic group represented by R⁰ in formula (3) include a straight-chain or branched alkyl group having from 1 to 12 carbon atoms, which may be substituted (for example, a methyl group, an ethyl group, a propyl group, a butyl group, a pentyl group, a hexyl group, a heptyl group, an octyl group, a nonyl group, a decyl group or a dodecyl group, and examples of the group substituted on the alkyl group include a halogen atom (for example, a chlorine atom, a fluorine atom or a bromine atom), a hydroxy group, a thiol group, a carboxyl group, a sulfo group, a cyano group, an epoxy group, an -OR' group (wherein R' represents, for example, an methyl group, an ethyl group, a propyl group, a butyl group, a heptyl group, a hexyl group, an octyl group, a decyl group, a propenyl group, a butenyl group, a hexenyl group, a octenyl group, a 2-hydroxyethyl group, a 3-chloropropyl group, a 2-cyanoethyl group, N,N-dimethylaminoethyl group, a 1-bromoethyl group, a 2-(2-methoxyethyl)oxyethyl group, a 2-methoxycarbonylethyl group, a 3-carboxypropyl group or a benzyl group), an -OCOR" group (wherein R" represents the group same as that defined for R' above), a -COOR" group, a -COR" group, an -N(R"')(R"') group (wherein R'" represents a hydrogen atom or the group same as that defined for R' above, and plural R"'s may be the same or different), an -NHCONHR" group, an -NHCOOR" group, an -Si(R")₃ group, a -CONHR" group and an -NHCOR" group (a plurality of the substituents may be present on the alkyl group),
a straight-chain or branched alkenyl group having from 2 to 12 carbon atoms, which may be substituted (for example, a vinyl group, a propenyl group, a butenyl group, a pentenyl group, a hexenyl group, an octenyl group, a decenyl group or a dodecenyl group, and examples of the group substituted on the alkenyl group include those substituted on the alkyl group described above, an aralkyl group having from 7 to 14 carbon atoms, which may be substituted (for example, a benzyl group, a phenethyl group, a 3-phenylpropyl group, a naphtylmethyl group or a 2-naphthylethyl group, examples of the group substituted on the aralkyl group include those substituted on the alkyl group described above, and a plurality of the substituents may be present on the aralkyl group),
an alicyclic group having from 5 to 10 carbon atoms, which may be substituted (for example, a cyclopentyl group, a cyclohexyl group, a 2-cyclohexylethyl group, a 2-cyclopentylethyl group, a norbornyl group or an adamantyl group, and examples of the group substituted on the alicyclic group include those substituted on the alkyl group described above, and a plurality of the substituents may be present on the alicyclic group), an aryl group having from 6 to 12 carbon atoms, which may be substituted (for example, a phenyl group or a naphthyl group, and examples of the substituent include those substituted on the alkyl group described above, and a plurality of the substituents may be present on the aryl group), and a heterocyclic group containing at least one kind of atom selected from a nitrogen atom, an oxygen atom and a sulfur atom, which may be condensed (for example, a pyran ring, a furan ring, a thiophene ring, a morpholine ring, a pyrrole ring, a thiazole ring, an oxazole ring, a pyridine ring, a piperidine ring, a pyrrolidone ring, a benzothiazole ring, a benzoxazole ring, a quinoline ring or a tetrahydrofuran ring, which may have a substituent, and examples of the substituent include those substituted on the alkyl group described above, and a plurality of the substituents may be present on the heterocyclic group).

Examples of the substituent on the groups -OR¹, -OCOR² and -N(R³)(R⁴) represented by Y in formula (3) include substituents described below. In the group -OR¹, R¹ represents an aliphatic group having from 1 to 10 carbon atoms, which may be substituted (for example, a methyl group, an ethyl group, a propyl group, a butyl group, a heptyl group, a hexyl group, a pentyl group, an octyl group, a nonyl group, a decyl group, a propenyl group, a butenyl group, a heptenyl group, a hexenyl group, an octenyl group, a decenyl group, a 2-hydroxyethyl group, a 2-hydroxypropyl group, a 2-methoxyethyl group, a 2-(methoxyethyloxo)ethyl group, a 1-(N,N-diethylamino)ethyl group, a 2-methoxypropyl group, a 2-cyanoethyl group, a 3-methyloxapropyl group, a 2-chloroethyl group, a cyclohexyl group, a cyclopentyl group, a cyclooctyl group, a chlorocyclohexyl group, a methoxycyclohexyl group, a benzyl group, a phenethyl group, a dimethoxybenzyl group, a methylbenzyl group or a bromobenzyl group).

In the group -OCOR², R² represents the aliphatic group same as that defined for R¹ or an aromatic group having from 6 to 12 carbon atoms, which may have a substituent (examples of the aromatic group include those described for the aryl group represented by R). In the group -N(R³)(R⁴), R³ and R⁴, which may be the same or different, each represents a hydrogen atom or an aliphatic group having from 1 to 10 carbon atoms, which may be substituted (for example, those described for R¹ in the group -OR¹). More preferably, a total number of the carbon atoms included in R³ and R⁴ is 16 or less.

Specific examples of the silane compound represented by formula (3) are set forth below, but the invention should not be construed as being limited thereto.

Examples thereof include tetrachlorosilane, tetrabromosilane, tetramethoxysilane, tetraethoxysilane, tetraisopropoxysilane, tetra-n-propylsilane, tetra-tert-butoxysilane, tetra-n-butoxysilane, dimethoxydiethoxysilane, methyltrichlorosilane, methyltribromosilane, methyltrimethoxysilane, methyltriethoxysilane, methyltriisopropoxysilane, methyltri-tert-butoxysilane, ethyltrichlorosilane, ethyltribromosilane, ethyltrimethoxysilane, ethyltriethoxysilane, ethyltriisopropoxysilane, ethyltri-tert-butoxysilane, n-propyltrichlorosilane, n-propyltribromosilane, n-propyltrimethoxysilane, n-propyltriethoxysilane, n-propyltriisopropoxysilane, n-propyltri-tert-butoxysilane, n-hexyltrichlorosilane, n-hexyltribromosilane, n-hexyltrimethoxysilane, n-hexyltriethoxysilane, n-hexyltriisopropoxysilane, n-hexyltri-tert-butoxysilane, n-decyltrichlorosilane, n-decyltriboromosilane, n-decyltrimethoxysilane, n-decyltriethoxysilane, n-decyltriisopropoxysilane, n-decyltri-tert-butoxysilane, n-octadecyltrichlorosilane, n-octadecyltribromosilane, n-octadecyltrimethoxysilane, n-octadecyltriethoxysilane, n-octadecyltriisopropoxysilane, n-octadecyltri-tert-butoxysilane, phenyltrichlorosilane, phenyltribromosilane, phenyltrimethoxysilane, phenyltriethoxysilane, phenyltriisopropoxysilane, phenyltri-tert-butoxysilane, dimethyldichlorosilane, dimethyldibromosilane, dimethyldimethoxysilane, dimethyldiethoxysilane, diphenyldichlorosilane, diphenyldibromosilane, diphenyldimethoxysilane, diphenyldiethoxysilane, phenylmethyldichlorosilane, phenylmethyldibromosilane, phenylmethyldimethoxysilane, phenylmethyldiethoxysilane,
triethoxyhydrosilane, tribromohydrosilane, trimethoxyhydrosilane, isopropoxyhydrosilane, tri-tert-butoxyhydrosilane, vinyltrichlorosilane, vinyltribromosilane, vinyltrimethoxysilane, vinyltriethoxysilane, vinyltriisopropoxysilane, vinyltri-tert-butoxysilane, trifluoroporpyltrichlorosilane, trifluoropropyltribromosilane, trifluoropropyltrimethoxysilane, trifluoropropyltriethoxysilane, trifluoropropyltriisopropoxysilane, trifluoropropyltri-tert-butoxysilane, γ-glycidoxypropylmethyldimethoxysilane, γ-glycidoxypropylmethyldiethoxysilane, γ-glycidoxypropyltrimethoxysilane, γ-glycidoxypropyltriethoxysilane, γ-glycidoxypropyltriisopropoxysilane, γ-glycidoxypropyltri-tert-butoxysilane, γ-methacryloxypropylmethyldimethoxysilane, γ-methacryloxypropylmethyldiethoxysilane, γ-methacryloxypropyltrimethoxysilane, γ-methacryloxypropyltriisopropoxysilane, γ-methacryloxypropyltri-tert-butoxysilane, γ-aminopropylmethyldimethoxysilane, γ-aminopropylmethyldiethoxysilane, γ-aminopropyltrimethoxysilane, γ-aminopropyltriethoxysilane, γ-aminopropyltriisopropoxysilane, v-aminopropyltri-tert-butoxysilane, γ-mercaptopropylmethyldimethoxysilane, γ-mercaptopropylmethyldiethoxysilane, γ-mercaptopropyltrimethoxysilane, γ-mercaptopropyltriethoxysilane, γ-mercaptopropyltriisopropoxysilane, γ-mercaptopropyltri-tert-butoxysilane, β-(3,4-epoxycyclohexyl)ethyltrimethoxysilane and β-(3,4-epoxycyclohexyl)ethyltriethoxysilane.

In order to accelerate the hydrolysis and polycondensation reaction of the silane compound represented by (3), it is preferred to use an acidic catalyst or a basic catalyst in combination. As the catalyst, an acid or a basic compound itself or that dissolved in water or a solvent, for example, an alcohol is used. The concentration is not particularly limited, and there is a tendency that the rate of the hydrolysis and polycondensation is increased when the concentration is high. However, when the basic catalyst of a high concentration is used, since a precipitate is formed in the sol solution in some cases, it is desired that the amount of the basic catalyst is IN (in terms of concentration in an aqueous solution) or less.

The kind of the acidic catalyst and the basic catalyst is not particularly limited. Specific examples of the acidic catalyst include hydrochloric acid, nitric acid, sulfuric acid, phosphoric acid, acetic acid, malic acid, oxalic acid and benzenesulfonic acid. Specific examples of the basic catalyst include ammonia, tetramethylammonium hydroxide, potassium hydroxide and sodium hydroxide.

The sol-gel method is described in more detail in books, for example, Sumio Sakuhana, Sol-gel Ho no Kagaku, published by Agune Shofu Sha (1988) and Hiroshi Hirashima, Saishin Sol-gel Ho niyoru Kinosei Hakumaku Sakusei Gijutu, published by Sougou Gijutu Center (1992).

The content of the inorganic hydrophilic matrix in the white layer is preferably from 10 to 90% by weight, more preferably from 20 to 80% by weight, based on the total solid content of the white layer.

### (Polymer having repeating unit containing at least one ethylenically unsaturated bond and repeating unit containing at least one functional group capable of interacting with surface of aluminum support)

The white layer according to the invention may contain a polymer (hereinafter, referred to as a "specific copolymer") having a repeating unit containing at least one ethylenically unsaturated bond and a repeating unit containing at least one functional group capable of interacting with a surface of an aluminum support for the purposes of increasing physical performance, for example, film strength or flexibility, of improving coating property and of controlling hydrophilicity. The specific copolymer preferably contains repeating units represented by formula (a) shown below.

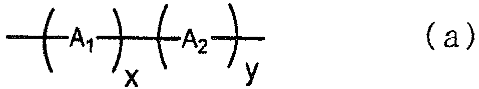

In formula (a), A₁ represents a repeating unit containing at least one ethylenically unsaturated bond, A₂ represents a repeating unit containing at least one functional group capable of interacting with a surface of an aluminum support, and x and y each represents a copolymerization ratio.

In formula (a), the repeating unit represented by A₁ is preferably represented by formula (A1) shown below.

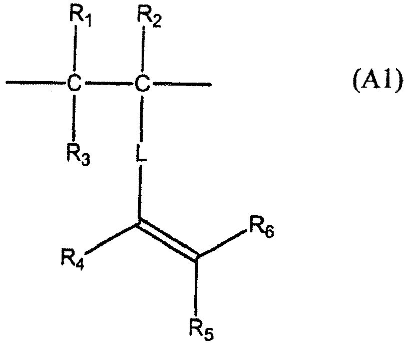

In the formula, R₁ to R₃ each independently represent a hydrogen atom, an alkyl group having from 1 to 6 carbon atoms or a halogen atom. R₄ to R₆ each independently represent a hydrogen atom, an alkyl group having from 1 to 6 carbon atoms, a halogen atom, an acyl group or an acyloxy group. Alternatively, R₄ and R₅ or R₅ and R₆ may be connected to form a ring. L represents a divalent connecting group selected from the group consisting of -CO-, -O-, -NH-, a divalent aliphatic group, a divalent aromatic group, and a combination thereof.

Specific examples of L composed of the combination of groups are set forth below. In each of the specific examples shown below, the left side is connected to the main chain and the right side is connected to the ethylenically unsaturated bond.
L1: -CO-NH-divalent aliphatic group-O-CO-
L2: -CO-divalent aliphatic group-O-CO-
L3: -CO-O-divalent aliphatic group-O-CO-
L4: -divalent aliphatic group-O-CO-
L5: -CO-NH-divalent aromatic group-O-CO-
L6: -CO-divalent aromatic group-O-CO-
L7: -divalent aromatic group-O-CO-
L8: -CO-O-divalent aliphatic group-CO-O-divalent aliphatic group-O-CO-
L9: -CO-O-divalent aliphatic group-O-CO-divalent aliphatic group-O-CO-
L10: -CO-O-divalent aromatic group-CO-O-divalent aliphatic group-O-CO-
L11: -CO-O-divalent aromatic group-O-CO-divalent aliphatic group-O-CO-
L12: -CO-O-divalent aliphatic group-CO-O-divalent aromatic group-O-CO-
L13: -CO-O-divalent aliphatic group-O-CO-divalent aromatic group-O-CO-
L14: -CO-O-divalent aromatic group-CO-O-divalent aromatic group-O-CO-
L15: -CO-O-divalent aromatic group-O-CO-divalent aromatic group-O-CO-
L16: -CO-O-divalent aromatic group-O-CO-NH-divalent aliphatic group-O-CO-
L17: -CO-O-divalent aliphatic group-O-CO-NH-divalent aliphatic group-O-CO-

The divalent aliphatic group includes an alkylene group, a substituted alkylene group, an alkenylene group, a substituted alkenylene group, an alkinylene group, a substituted alkinylene group and a polyalkyleneoxy group. Among them, an alkylene group, a substituted alkylene group, an alkenylene group and a substituted alkenylene group are preferred, and an alkylene group and a substituted alkylene group are more preferred.

Of the divalent aliphatic groups, a chain structure is preferred than a cyclic structure, and further a straight-chain structure is more preferred than a branched chain structure.

A number of carbon atoms included in the divalent aliphatic group is preferably from 1 to 20, more preferably from 1 to 15, still more preferably from 1 to 12, yet still more preferably from 1 to 10, and most preferably from 1 to 8.

Examples of the substituent for the divalent aliphatic group include a halogen atom (e.g., F, Cl, Br or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, an arylamino group and a diarylamino group.

The divalent aromatic group includes an arylene group and a substituted arylene group. It preferably includes a phenylene group, a substituted phenylene group, a naphthylene group and a substituted naphthylene group.

Examples of the substituent for the divalent aromatic group include an alkyl group in addition to the substituents described for the divalent aliphatic group above.

Of L1 to L17 described above, L1, L3, L5, L7 and L17 are preferred.

The repeating unit represented by A₂ in formula (a) is specifically represented by formula (A2) shown below.

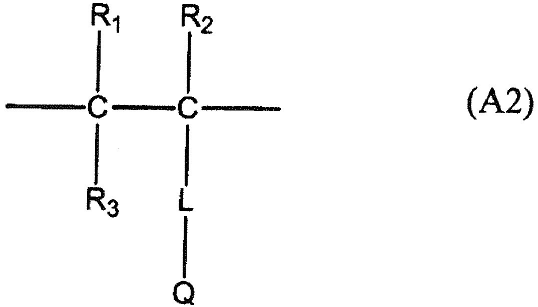

In the formula, R₁ to R₃ and L have the same meanings as those in formula (A1). Q represents a functional group capable of interacting with a surface of an aluminum support (hereinafter, abbreviated as a "specific functional group" sometimes).

Examples of the specific functional group include a group capable of forming a bond, for example, a covalent bond, an ionic bond or a hydrogen bond and a group capable of undergoing interaction, for example, polar interaction or van der Waals interaction, with metal, a metal oxide, a hydroxy group or the like present on the support subjected to an anodizing treatment or a hydrophilizing treatment.

Specific examples of the specific functional group are set forth below.

**-PO₃H₂ -SO₃M₁ -OSO₃M₁**

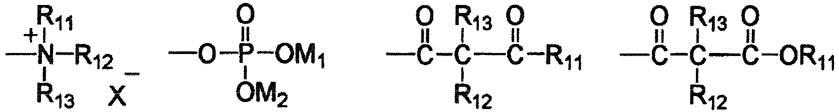

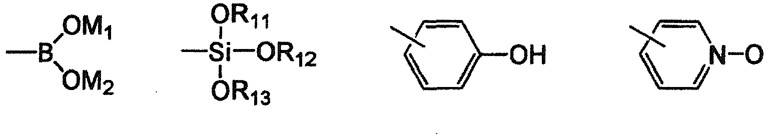

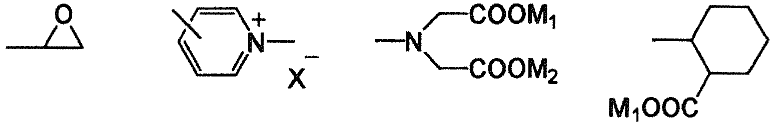

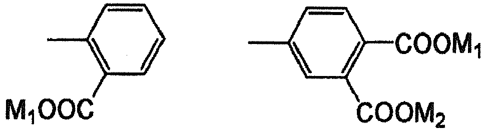

In the formulae, R₁₁ to R₁₃ each independently represents a hydrogen atom, an alkyl group, an aryl group, an alkynyl group or an alkenyl group, M₁ and M₂ each independently represents a hydrogen atom, a metal atom or an ammonium group, and X⁻ represents a counter anion.

Among them, as the specific functional group, an onium salt group, for example, an ammonium group or a pyridinium group, a phosphoric acid ester group, a phosphonic acid group, a boric acid group and a β-diketone group, for example, an acetylacetone group are preferred.

L in formula (A2) represents a divalent connecting group selected from the group consisting of -CO-, -O-, -NH-, a divalent aliphatic group, a divalent aromatic groups, and a combination thereof.

Specific examples of L composed of the combination of groups include the groups set forth below in addition to the specific examples set forth for L in formula (A1). In each of the specific examples shown below, the left side connects to the main chain.
L18: -CO-NH-
L19: -CO-O-
L20: -divalent aromatic group-

The repeating unit represented by formula (A2) may have a hydrophilic moiety therein. In the case where formula (A2) does not contain a hydrophilic moiety, it is preferred that the copolymer to be used in the invention preferably further contain a repeating unit represented by the formula (A3) shown below as a copolymerization component.

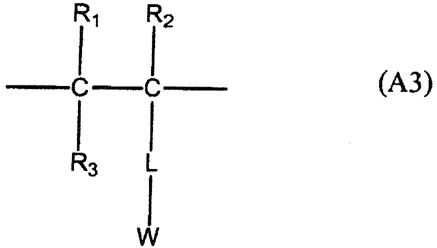

In the formula, R₁ to R₃ and L have the same meanings as those in formula (A1). W represents a hydrophilic group shown below.

**-COO-M₁, -SO₃-M₁,**

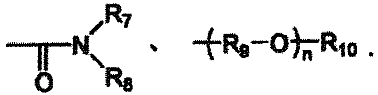

In the formulae, M₁ has the same meaning as that in formula (A2).

R₇ and R₈ each independently represent a hydrogen atom or a straight-chain or branched alkyl group having from 1 to 6 carbon atoms. R₉ represents a straight-chain or branched alkylene group having from 1 to 6 carbon atoms, and is preferably an ethylene group. R₁₀ represents a hydrogen atom or an alkyl group having from 1 to 12 carbon atoms. n represents an integer from 1 to 100, and preferably from 1 to 30.

The repeating unit having at least one hydrophilic group represented by formula (A3) has a log P of preferably from -3 to 3, and more preferably from -1 to 2. In the range described above, good on-press development property is obtained.

The term log P as used herein means a logarithm of a distribution coefficient (P) of a compound in octanol/water which is calculated using software PC Models developed by Medicinal Chemistry Project, Pomona College, Claremont, California and available from Daylight Chemical Information System Inc.

W is preferably a group containing an alkyleneoxy group.

The molecular weight of the specific copolymer is preferably in a range from 500 to 100,000, more preferably in a range from 700 to 50,000, in terms of weight average molecular weight (Mw). The proportion of (a1) is preferably from 5 to 80% by mole, more preferably from 10 to 50% by mole, based on the total copolymerization monomers. The proportion of (a2) is preferably from 5 to 80% by mole, more preferably from 10 to 50% by mole, based on the total copolymerization monomers. Furthermore, the proportion of (a3) is preferably from 5 to 80% by mole, more preferably from 10 to 50% by mole, based on the total copolymerization monomers.

Specific examples of the specific copolymer for use in the invention are set forth below, but the invention should not be construed as being limited thereto. In the compounds shown below, x, y, z and w attached to the respective repeating units (x, y, z and w attached to the repeating unit of the main chain) represents a molar percentage of the repeating unit. The numerical value attached to the repeating unit of the side chain represents a repeating number of the repeating unit.

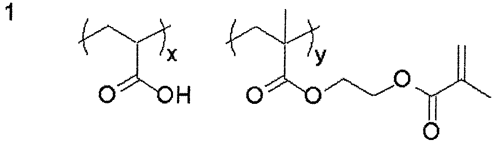

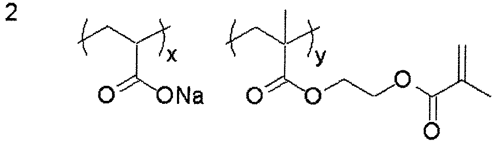

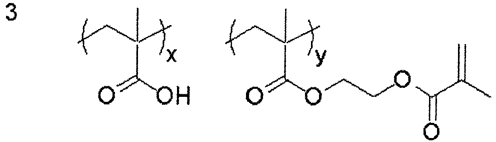

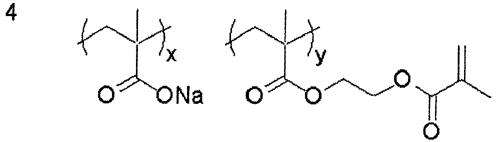

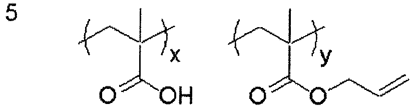

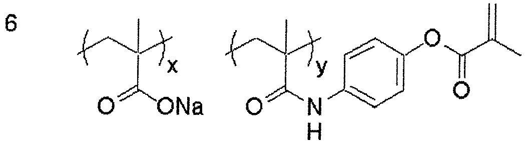

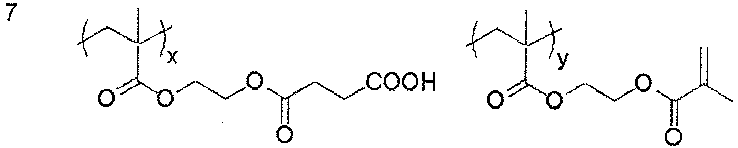

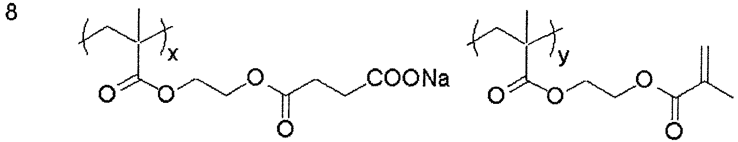

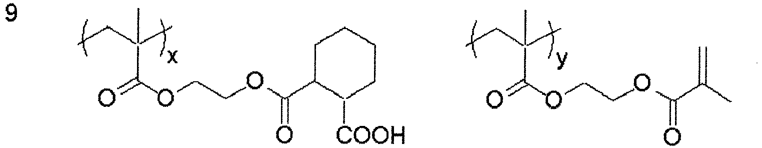

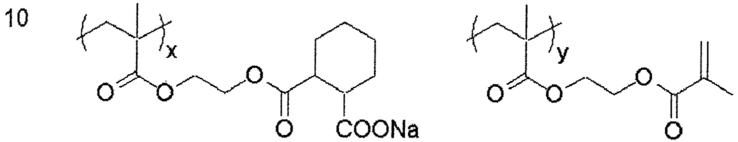

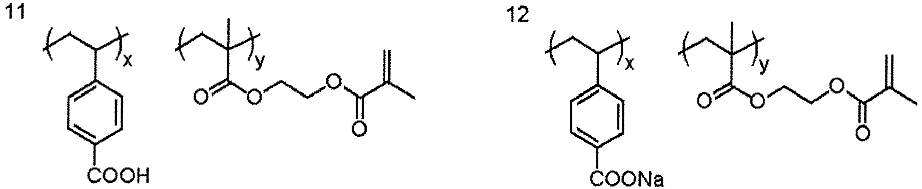

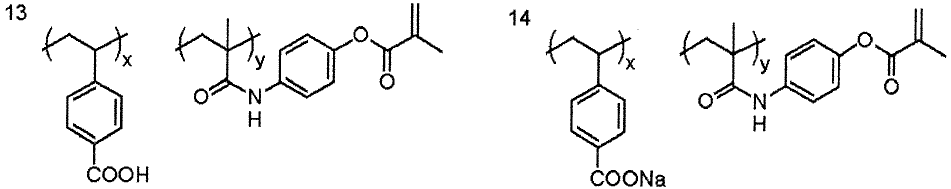

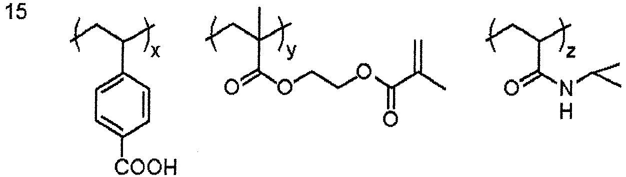

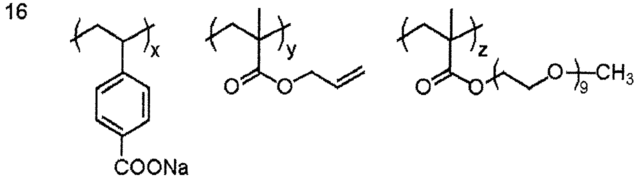

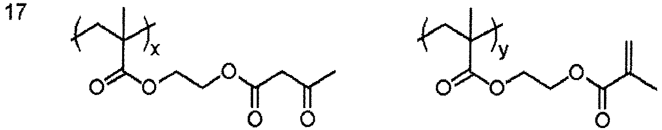

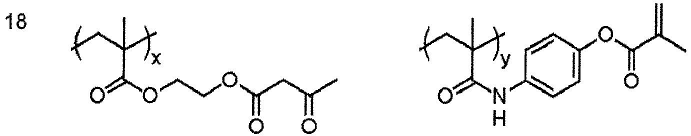

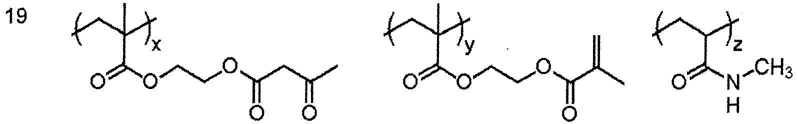

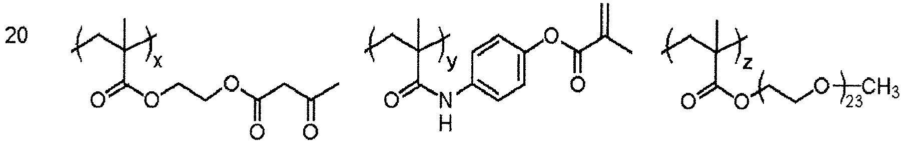

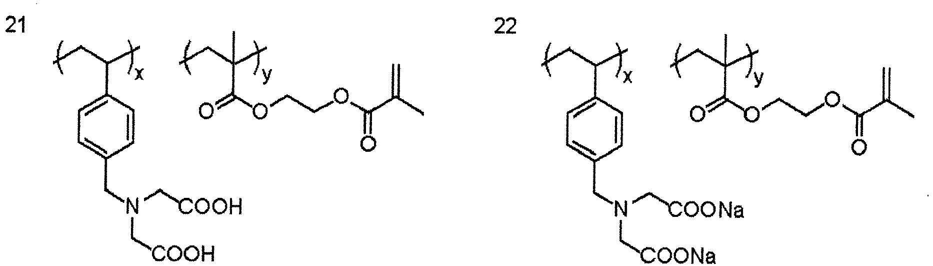

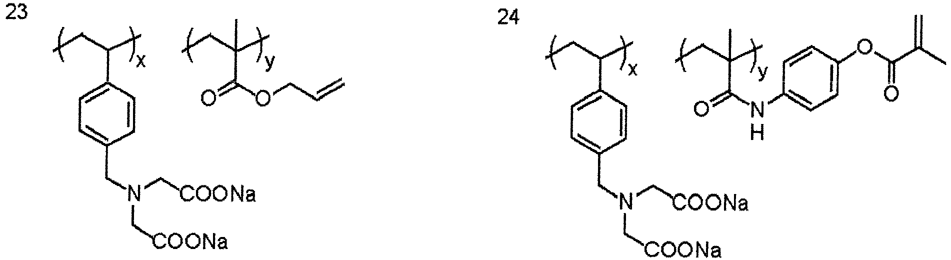

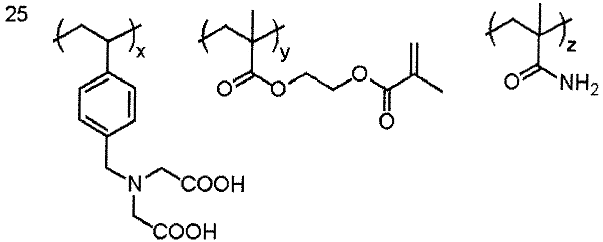

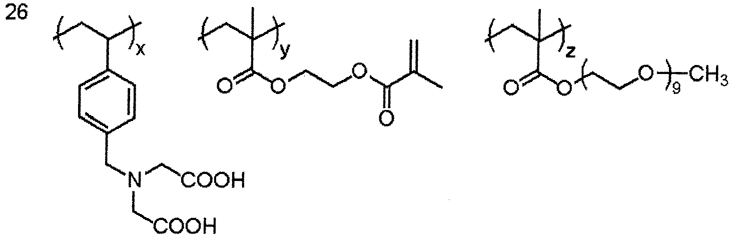

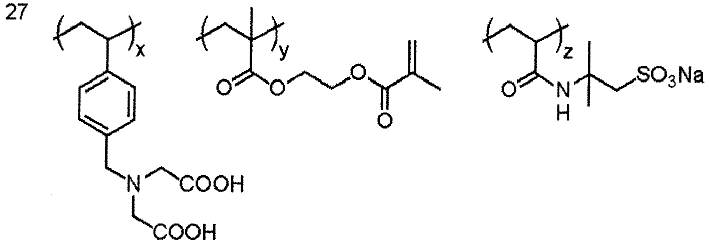

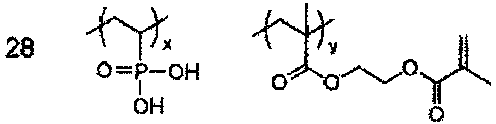

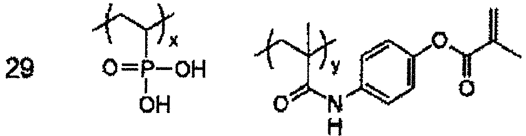

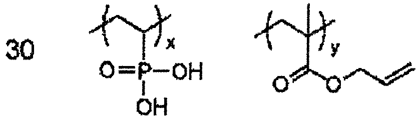

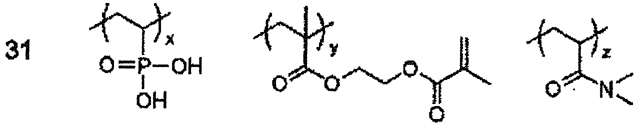

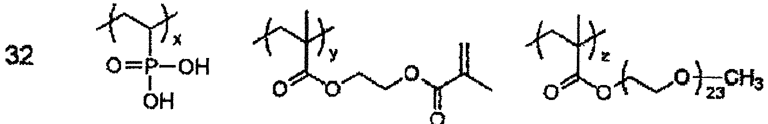

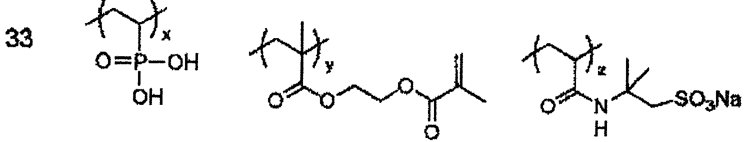

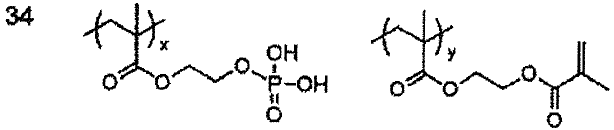

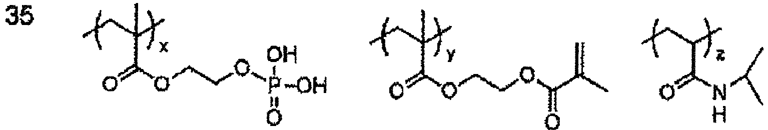

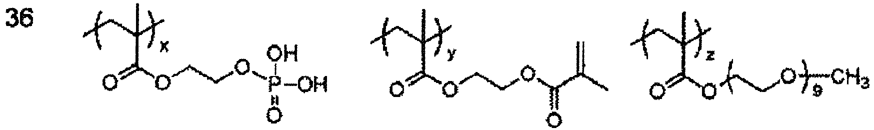

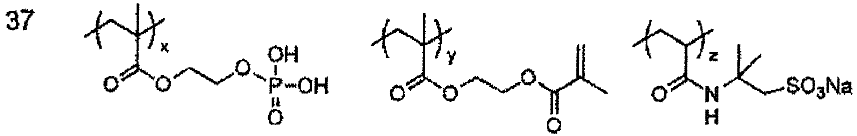

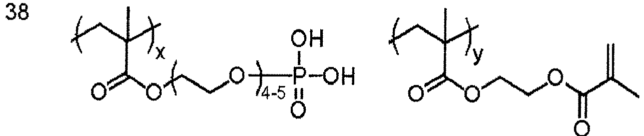

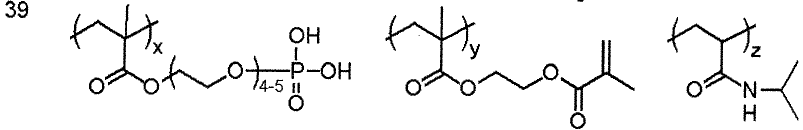

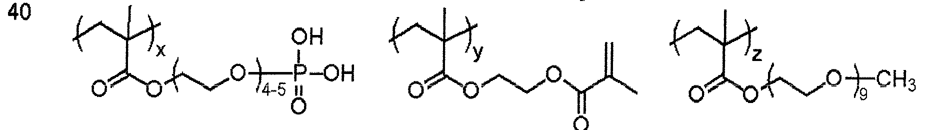

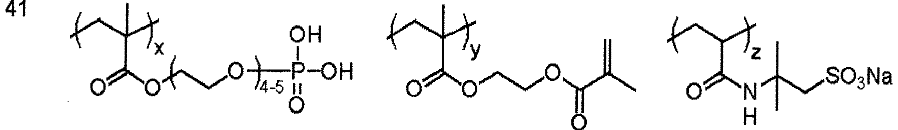

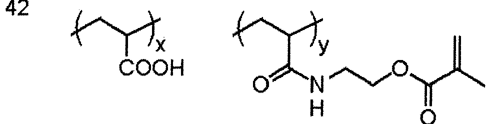

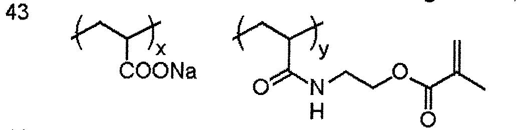

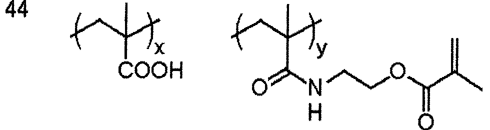

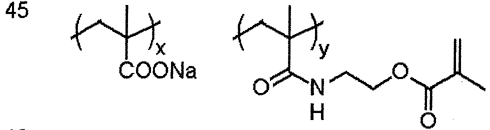

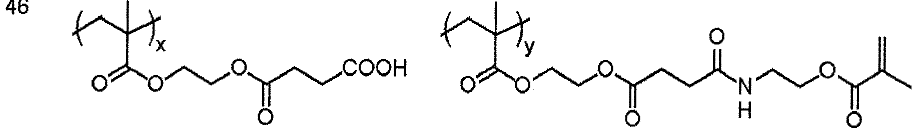

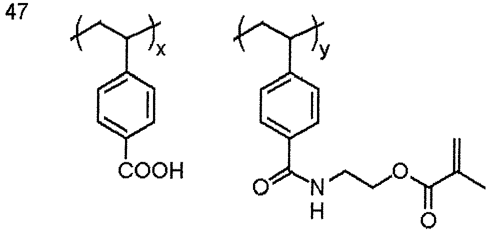

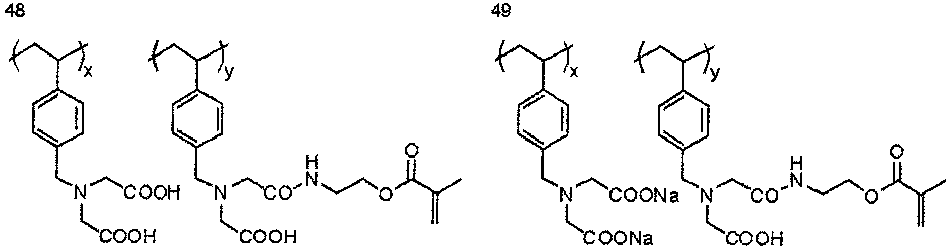

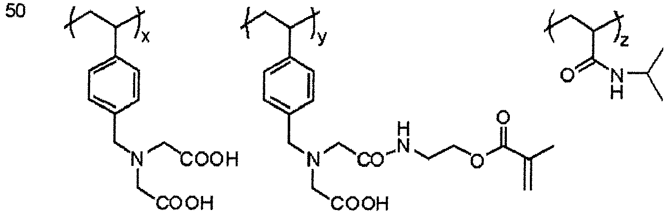

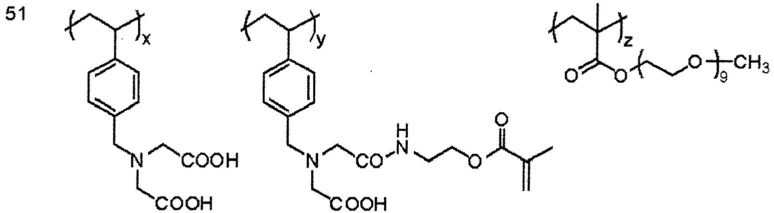

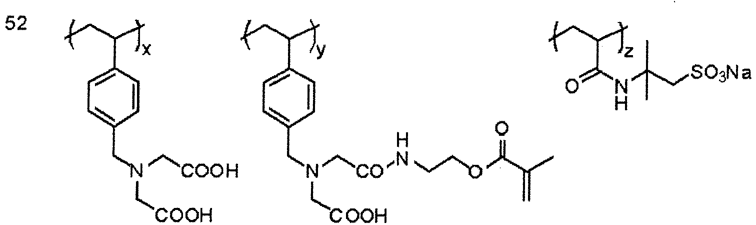

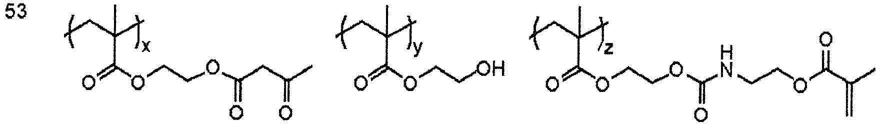

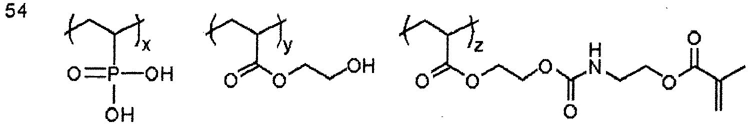

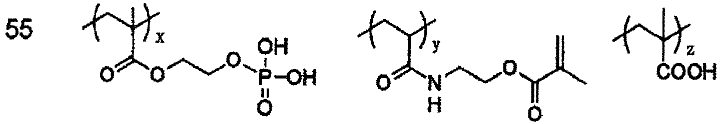

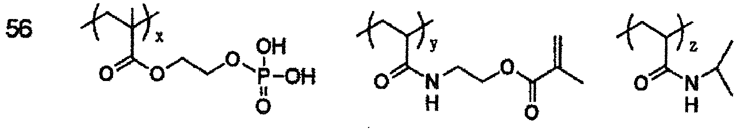

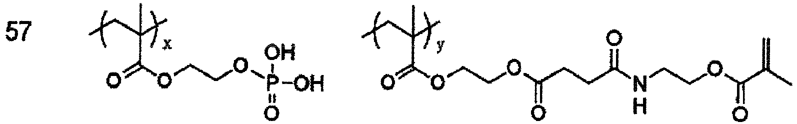

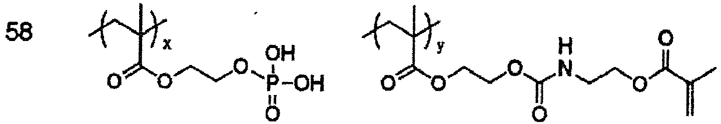

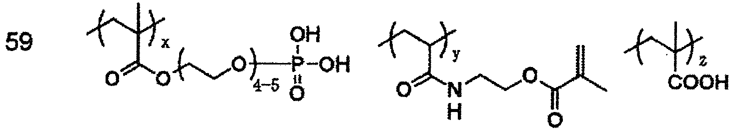

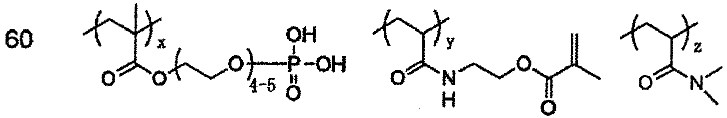

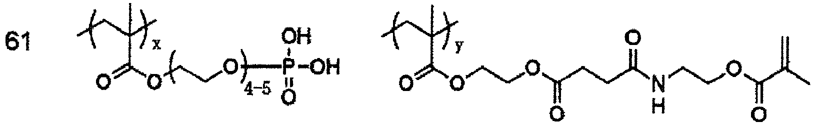

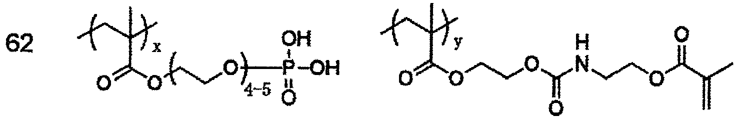

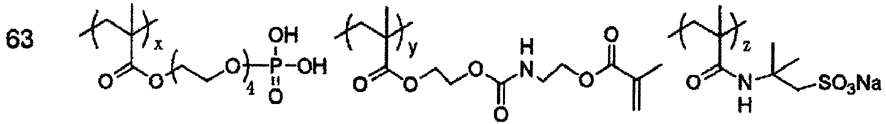

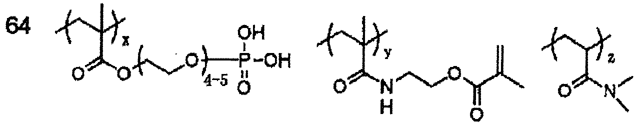

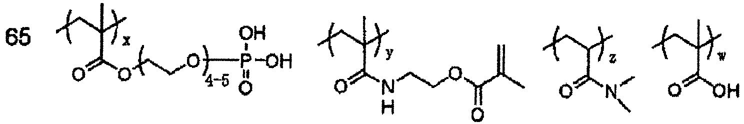

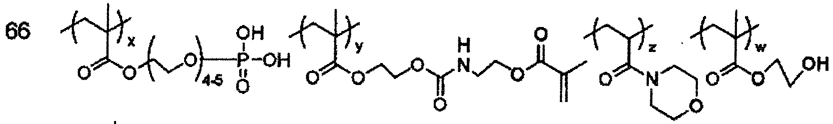

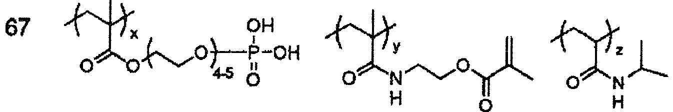

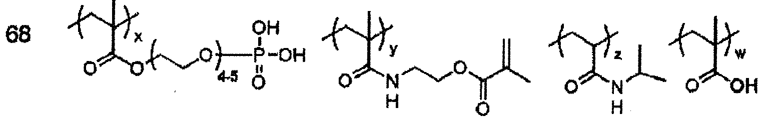

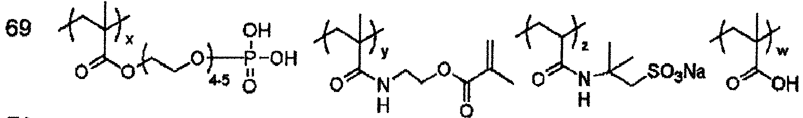

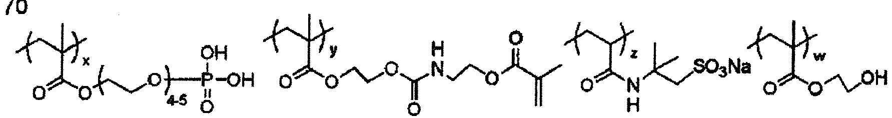

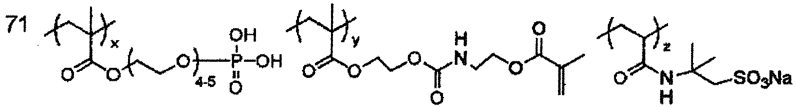

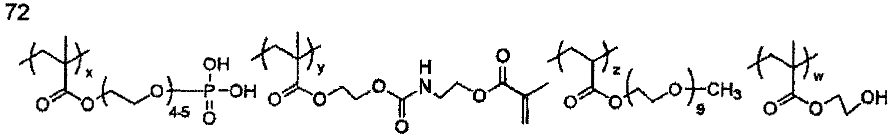

The content of the specific copolymer contained in the white layer is preferably from 5 to 20% by weight based on the total solid content of the white layer.

### (Other components)

Compounds for various purposes, for example, of controlling the extent of hydrophilicity, increasing physical strength of the hydrophilic layer, increasing dispersibility of the mutual compositions constituting the layer, increasing coating property or increasing printing aptitude may be added to the white layer according to the invention in addition to the components described above. Examples of the other components include a hydrophilic polymer other than the specific copolymer (for example, polyvinyl alcohol (polyvinyl acetate having a saponification degree of 60% or more), modified polyvinyl alcohol, for example, carboxyl-modified polyvinyl alcohol, starch and a derivative thereof, a cellulose derivative, for example, carboxymethyl cellulose and a salt thereof or hydroxyethyl cellulose, casein, gelatin, gum arabic, polyvinyl pyrrolidone, a vinyl acetate-crotonic acid copolymer and a salt thereof, a styrene-maleic acid copolymer and a salt thereof, polyacrylic acid and a salt thereof, polymethacrylic acid and a salt thereof, polyethylene glycol, polyethyleneimine, polyvinyl phosphonic acid and a salt thereof, polystyrene sulfonic acid and a salt thereof, poly(methacryloyloxypropanesulfonic acid) and a salt thereof, polyvinyl sulfonic acid and a salt thereof, poly(methacryloyloxyethyltrimethylammonium chloride), polyhydroxyethyl methacrylate, polyhydroxyethyl acrylate and polyacrylamide), a plasticizer, a surfactant and a hydrophilic particle.

### (Formation of white layer)

The white layer for use in the invention is formed, for example, by dissolving or dispersing the necessary components in an appropriate solvent, for example, water or a polar solvent, for example, methanol or ethanol, solely or as a mixed solvent thereof, and coating, drying and curing the resulting solution or dispersion on the support.

The coating amount of the white layer is preferably from 0.05 to 0.6 g/m², more preferably from 0.07 to 0.5 g/m², and still more preferably from 0.1 to 0.4 g/m².

### [Aluminum support]

The aluminum support for use in the invention is a pure aluminum plate, an alloy plate containing aluminum as the main component and a slight amount of foreign atom or a thin film of aluminum or an aluminum alloy laminated with plastic. Examples of the foreign element contained in the aluminum alloy include silicon, iron, manganese, copper, magnesium, chromium, zinc, bismuth, nickel and titanium. The content of the foreign element in the alloy is preferably 10% by weight or less. Although the pure aluminum plate is preferred in the invention, an aluminum plate containing a slight amount of foreign element may be used because completely pure aluminum is difficult to produce in view of refining technique. The aluminum plate to be used is not limited in the composition thereof, and conventionally known and commonly used aluminum materials can be appropriately utilized.

The thickness of the support is preferably from 0.1 to 0.6 mm, more preferably from 0.15 to 0.4 mm, and still more preferably from 0.2 to 0.3 mm.

Prior to using the aluminum plate, it is subjected to a roughening treatment, an anodizing treatment and, if desired, a hydrophilizing treatment. By such a surface treatment, increase in hydrophilicity and securement of the adhesion property between the image-recording layer and the support are easily achieved. Before being subjected to the roughening treatment, the aluminum plate may be subjected to a degreasing treatment with a surfactant, an organic solvent, an alkaline aqueous solution or the like to remove a rolling oil remaining on the surface thereof, if desired.

### (Roughening treatment)

The roughening treatment method includes a method of mechanically roughening, chemical etching and electrolytic graining as disclosed in JP-B-56-28893. Further, there may be employed an electrochemical roughening method of electrochemically roughening the surface in an electrolytic solution of hydrochloric acid or nitric acid and a mechanical roughening method, for example, a wire brush graining method of scratching the aluminum surface with a metal wire, a ball graining method of graining the aluminum surface with graining balls and an abrasive and a brush graining method of roughening the aluminum surface with a nylon brush and an abrasive. The roughening methods may be used individually or in combination thereof.

Of the methods, a method useful for the roughening is the electrochemical method of chemically roughening the surface in an electrolytic solution of hydrochloric acid or nitric acid, and an appropriate quantity of electricity at anodic time is in a range from 50 to 400 C/dm². More specifically, it is preferred to conduct alternating current and/or direct current electrolysis in an electrolytic solution containing from 0.1 to 50% hydrochloric acid or nitric acid under the conditions of from 20 to 80°C in temperature, from one second to 30 minutes in time and from 10 to 50 A/dm² in electric current density.

### (Etching treatment)

The aluminum support subjected to the roughening treatment is preferably chemically etched with an acid or alkali. The etching agent preferably used include, for example, sodium hydroxide, sodium carbonate, sodium aluminate, sodium metasilicate, sodium phosphate, potassium hydroxide and lithium hydroxide. The concentration is preferably from 1 to 50% by weight, the temperature is preferably from 20 to 100°C, and the time is preferably from 1 to 10 seconds. More preferred ranges of the concentration, temperature and time are from 10 to 50% by weight, from 45 to 90°C and from 2 to 9 seconds, respectively, and still more preferred ranges of the concentration, temperature and time are from 20 to 45% by weight, from 70 to 90°C and from 3 to 8 seconds, respectively.

Due to the etching treatment, the steepness degree a45 on the surface of aluminum is reduced, thereby decreasing the reflection density of the aluminum support.

In order to remove the stain (smut) remaining on the surface after the etching, washing with an acid is conducted. Examples of the acid used include nitric acid, sulfuric acid, phosphoric acid, chromic acid, hydrofluoric acid and borofluoric acid.

### (Anodizing treatment)

The aluminum support thus-treated is then subjected to an anodizing treatment. In the anodizing treatment, sulfuric acid, phosphoric acid, oxalic acid or an aqueous solution of boric acid/sodium borate is used individually or in combination of two or more thereof as the main component of an electrolytic bath. In this case, at least ingredients commonly contained in an aluminum alloy plate, an electrode, tap water, groundwater and the like may of course be contained in the electrolytic solution. Further, a second or third component may be added. Examples of the second or third component include a cation, for example, an ion of metal, for example, Na, K, Mg, Li, Ca, Ti, Al, V, Cr, Mn, Fe, Co, Ni, Cu or Zn or an ammonium ion, and an anion, for example, a nitrate ion, a carbonate ion, a chloride ion, a phosphate ion, a fluoride ion, a sulfite ion, a titanate ion, a silicate ion or a borate ion. It is allowed to be contained in a concentration approximately from 0 to 10,000 ppm. As to the conditions of the anodizing treatment, the amount of anodized film produced by the treatment is in a range from 0.5 to 10.0 g/m², more preferably in a range from 1.0 to 5.0 g/m². The treatment is preferably conducted by direct current or alternating current electrolysis of from 30 to 500 g/liter in concentration of acid as the main component of the electrolytic solution, from 10 to 70°C in temperature and from 0.1 to 40 A/m² in electric current density.

### (Hydrophilizing treatment)

For the hydrophilizing treatment of the surface of support, known methods are widely used. The hydrophilizing treatment with an alkali metal silicate or polyvinyl phosphonic acid or the like is particularly preferably conducted. The element amount of Si or P in the film formed is from 2 to 40 mg/m², and more preferably from 4 to 30 mg/m². The coating amount is measured by a fluorescent X-ray analysis method.

The hydrophilizing treatment is conducted by immersing the aluminum support having the anodized film in an aqueous solution containing an alkali metal silicate (for example, sodium silicate, potassium silicate or lithium silicate) or polyvinyl phosphonic acid in an amount from 1 to 30% by weight, preferably from 2 to 15% by weight, and having pH at 25°C from 10 to 13, at from 15 to 80°C and for from 0.5 to 120 seconds.

The aluminum support according to the invention is preferred to have a low reflection density on the surface of support. The support having the a45 of 30% or less due to the reduction of the steepness degree a45 by the etching treatment after the completion of the roughening treatment has the reflection density of the surface is 0.25 or less and thus, it can be used as the white substrate according to the invention without providing the white layer.

The substrate having the white layer provided on the support having the steepness degree a45 of 30% or less is also the white substrate according to the invention, and it exhibits particularly high visibility of the print-out image because the reflection density is more decreased.

### [Image-recording layer]

The image-recording layer according to the invention has a feature of containing an infrared absorbing agent, an onium salt polymerization initiator, a polymerizable compound and a color-forming compound and capable of being removed with at least any one of printing ink and dampening water. The image-recording layer according to the invention may contain known compounds other than those described above, if desired.

### (Infrared absorbing agent)

The infrared absorbing agent which can be used in the invention is preferably a dye or pigment having an absorption maximum in a wavelength range from 760 to 1,200 nm.

As the dye, commercially available dyes and known dyes described in literatures, for example, Senryo Binran compiled by The Society of Synthetic Organic Chemistry, Japan (1970) can be utilized. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes. Examples of preferred dye include cyanine dyes described, for example, in JP-A-58-125246, JP-A-59-84356 and JP-A-60-78787, methine dyes described, for example, in JP-A-58-173696, JP-A-58-181690 and JP-A-58-194595, naphthoquinone dyes described, for example, in JP-A-58-112793, JP-A-58-224793, JP-A-59-48187, JP-A-59-73996, JP-A-60-52940 and JP-A-60-63744, squarylium dyes described, for example, in JP-A-58-112792, and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferred examples of the dye include near infrared absorbing dyes represented by formulae (I) and (II) in U.S. Patent 4,756,993.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As a particularly preferred example of the dye, a cyanine dye represented by formula (1) shown below is exemplified.

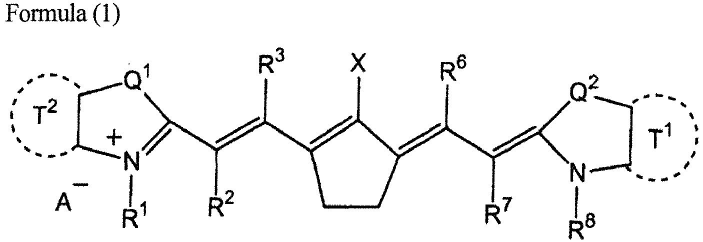

In the formula, R¹ and R⁸ each independently represents a monovalent substituent. The monovalent substituent represented by R¹ or R⁸ includes a hydrocarbon group having 20 or less carbon atoms, which may have a substituent. Preferred examples of the substituent include an alkoxy group having 12 or less carbon atoms, a carboxyl group or a sulfo group. R², R³, R⁶ and R⁷ each independently represents a hydrogen atom or a hydrocarbon group. In view of the availability of raw materials, a hydrogen atom is preferred. X represents -NPh₂ (wherein Ph represents a phenyl group). Q¹ and Q² each independently represents -NR⁹-, a sulfur atom, an oxygen atom or a dialkylmethylene group. R⁹ represents a hydrogen atom or a hydrocarbon group which may have a substituent. T¹ and T² each independently represents an aromatic ring or a heteroaromatic ring. Preferred examples of the aromatic ring include a benzene ring and a naphthalene ring. Preferred examples of the substituent include a hydrocarbon group having 12 or less carbon atoms, a halogen atom and an alkoxy group having 12 or less carbon atoms. A⁻represents an anion.

From the standpoint of sensitivity, each of R¹ and R⁸ is preferably an alkyl group or a substituted alkyl group, and most preferably an alkyl group substituted with a hetero atom. X is preferably -NPh₂. Q¹ and Q² preferably have the same structures, and a dialkylmethylene group is most preferred. The anion represented by A⁻ is not necessary when the cyanine dye represented by formula (1) has an anionic substituent in the structure thereof and neutralization of charge is not needed. In view of the preservation stability of a coating solution for image-recording layer, A⁻ is preferably a halide ion, a perchlorate ion, a tetrafluoroborate ion, a hexafluorophosphate ion or a sulfonate ion, and particularly preferably a perchlorate ion, a hexafluorophosphate ion or an arylsulfonate ion.

As a combination of each portion, a combination wherein each of R¹ and R⁸ is a substituted alkyl group, each of R², R³, R⁶ and R⁷ is a hydrogen atom, X is -NPh₂, and each of Q¹ and Q² is a dialkylmethylene group is particularly preferred.

Specific examples of the cyanine dye represented by formula (1) preferably used in the invention include dyes shown below.

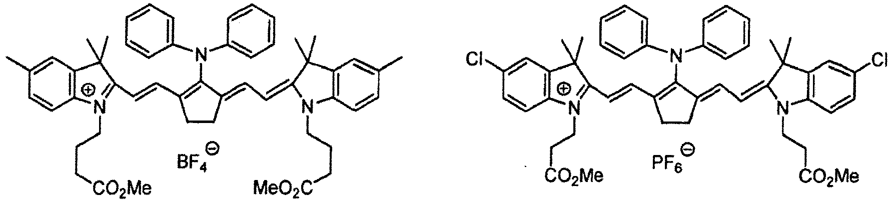

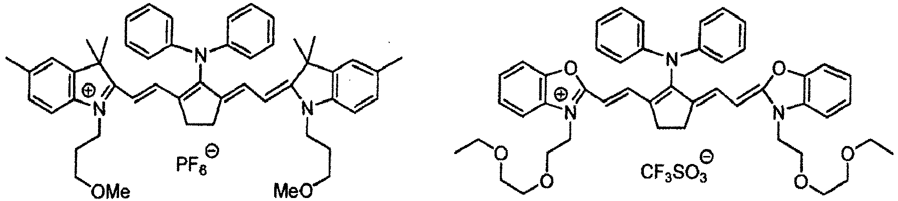

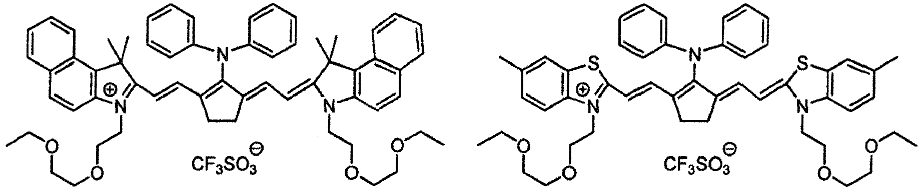

The infrared absorbing agent is preferably water-soluble, and when it is water-insoluble, it can also be added by using a method, for example, of dispersing or dissolving in a mixed solvent.

The infrared absorbing agent is preferably added to the image-recording layer in a minimum necessary amount in order to suppress the adverse effect inhibiting the polymerization reaction.

The infrared absorbing agent is added in an amount from 0.001 to 50% by weight, preferably from 0.005 to 30% by weight, particularly preferably from 0.01 to 10% by weight, based on the total solid content of the image-recording layer. In the range described above, high sensitivity is obtained without exerting undesirable influence on the uniformity and film strength of the image-recording layer.

### (Onium salt polymerization initiator)

The onium salt polymerization initiator functions not only as a radical generator but also as an acid generator in the invention. It accelerates polymerization and crosslinking of a polymerizable compound and a polymer having a polymerizable group, as the radical initiator and contributes to a reaction with a cyanine dye. It contributes color formation in combination with an acid color-forming agent, as the acid generator.

According to the invention, any one of the onium salt polymerization initiators represented by formulae (4) to (6) is used. A sulfonium salt or an iodonium salt represented by formula (4) or (5) is more preferred.

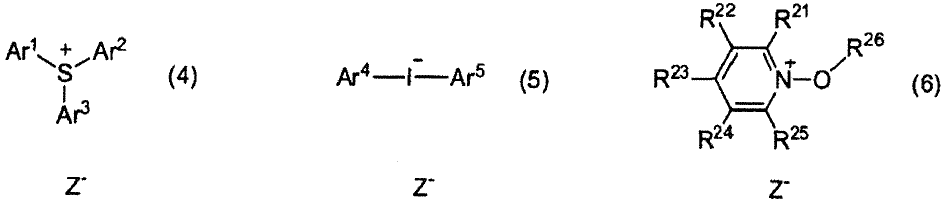

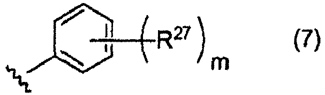

In the formulae, Ar¹, Ar², Ar³, Ar⁴ and Ar⁵ each independently represents a group represented by formula (7). R²¹, R²², R²³, R²⁴ and R²⁵ each independently represents a hydrogen atom, an alkyl group, an alkoxy group, an aryl group, a cyano group or a halogen atom, or R²¹ and R²² or R²² and R²³ may be combined with each other to form a condensed ring structure. R²⁶ represents an alkyl group or an aryl group. Z⁻ represents an anion.

In formula (7), R²⁷ represents an alkyl group, an alkoxy group or a halogen atom, and plural R²⁷s may be the same or different. m represents an integer from 0 to 5.

In formula (4), Ar¹, Ar² and Ar³ each more preferably represents a group represented by formula (10) shown below. In formula (5), Ar⁴ and Ar⁵ each more preferably represents a group represented by formula (11) shown below.

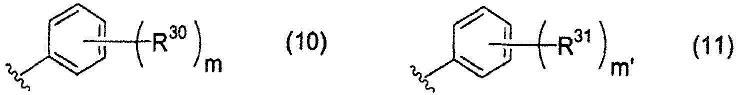

In formulae (10) and (11), R³⁰ represents a halogen atom, and plural R³⁰s may be the same or different. R³¹ represents an alkyl group or an alkoxy group, and plural R³¹s may be the same or different. m and m' each represents an integer from 0 to 5.

The alkyl group represented by any of R²¹, R²², R²³, R²⁴, R²⁵, R²⁶, R²⁷ and R³¹ is preferably an alkyl group having from 1 to 20 carbon atoms, more preferably an alkyl group having from 1 to 10 carbon atoms, and most preferably an alkyl group having from 1 to 4 carbon atoms.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, 1-methylbutyl group, an isohexyl group, a 2-ethylhexyl group, a 2-methylhexyl group, a cyclohexyl group, a cyclopentyl group and a 2-norbornyl group.

Of the alkyl groups, a methyl group, an ethyl group, a propyl group, a butyl group and a tert-butyl group are particularly preferred.

In the case where any of R²¹, R²², R²³, R²⁴, R²⁵, R²⁷ and R³¹ represents an alkoxy group, it is represented by an alkyl group-O-, and a preferred embodiment of the alkyl group is same as the preferred embodiment of the alkyl group in the case where any of R²¹, R²², R²³, R²⁴, R²⁵, R²⁶, R²⁷ and R³¹ represents the alkyl group.

The aryl group represented by any of R²¹, R²², R²³, R²⁴, R²⁵ and R²⁶ is preferably an aryl group having from 6 to 30 carbon atoms, more preferably an aryl group having from 6 to 20 carbon atoms, and most preferably an aryl group having from 6 to 12 carbon atoms.

Specific examples of the aryl group include a phenyl group, a biphenyl group, a 1-naphthyl group, a 2-naphthyl group, a 9-fluorenyl group, a terphenyl group, an o-, m- or p-tolyl group, a xylyl group, an o-, m- or p-cumenyl group, a mesityl group, a biphenylenyl group, an indacenyl group, a fluorenyl group, a p-chlorophenyl group, a p-bromophenyl group, a p-fluorophenyl group, an o-chlorophenyl group, an o-bromophenyl group, an o-fluorophenyl group, a p-methoxyphenyl group, a m-methoxyphenyl group, a p-dimethylaminophenyl group, a p-methylthiophenyl group, a m-methylthiophenyl group, p-phenyltiophenyl group, a 2,3-difluorophenyl group, a 2,3-dichlorophenyl group, a 2,4-difluorophenyl group, a 2,4-dichlorophenyl group, a 2,5-difluorophenyl group, a 2,5-dichlorophenyl group, a 2,6-difluorophenyl group, a 2,6-dichlorophenyl group, a 2,4,6-trifluorophenyl group, a 2,4,6-trichlorophenyl group, a 3,4,5-trifluorophenyl group and a 3,4,5-trichlorophenyl group.

Of the aryl groups, a phenyl group, a p-methoxyphenyl group and a p-dimethylaminophenyl group are particularly preferred.

The anion represented by Z⁻ preferably includes a halide ion, a perchlorate ion, a tetrafluoroborate ion, a hexafluorophosphate ion and a sulfonate ion, and is particularly preferably a perchlorate ion, a hexafluorophosphate ion and an arylsulfonate ion and most preferably a hexafluorophosphate ion.

Preferred specific examples of the onium salt polymerization initiator are set forth below, but the invention should not be construed as being limited thereto.

Examples of the compound (sulfonium salt) represented by formula (4) include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate, tris(4-chlorophenyl)sulfonium hexafluorophosphate, tris(2,4-dichlorophenyl)sulfonium hexafluorophosphate, bis(2,4-dichlorophenyl)phenylsulfonium hexafluorophosphate and bis(2,4-dichlorophenyl)-4-methoxyphenylsulfonium hexafluorophosphate.

Examples of the compound (iodonium salt) represented by formula (5) include diphenyliodonium hexafluorophosphate, 4-methoxyphenyl-4-(2-methylpropyl)phenyliodonium hexafluorophosphate, 4-chlorophenyl-4-phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium hexafluorophosphate.

Examples of the compound (azinium salt) represented by formula (6) include 1-cyclohexylinethyloxypyridinium hexafluorophosphate, 1-cyclohexyloxy-4-phenylpyridinium hexafluorophosphate, 1-methoxypyridinium hexafluorophosphate, 1-methoxy-4-tert-butylpyridinium hexafluorophosphate, 1-methoxy-4-methoxypyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1 -ethoxy-4-cyanopyridinium hexafluorophosphate, 3,4-dichloro-1-(2-ethylhexyloxy)pyridinium hexafluorophosphate, 1 -benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The onium alt polymerization initiator according to the invention is added in an amount from 0.1 to 50% by weight, more preferably 0.5 to 30% by weight, particularly preferably 0.8 to 25% by weight, based on the total solid content constituting the image-recording layer.

### (Polymerizable compound)

The polymerizable compound used in the image-recording layer according to the invention is an addition-polymerizable compound having at least one ethylenically unsaturated double bond, and it is selected from compounds having at least one, preferably two or more, terminal ethylenically unsaturated double bonds. Such compounds are widely known in the field of art and they can be used in the invention without any particular limitation. The compound has a chemical form, for example, a monomer, a prepolymer, specifically, a dimer, a trimer or an oligomer, or a mixture thereof, or a copolymer thereof. Examples of the monomer and copolymer thereof include an unsaturated carboxylic acid (for example, acrylic acid, methacrylic acid, itaconic acid, crotonic acid, isocrotonic acid or maleic acid), an ester thereof and an amide thereof. Preferably, an ester of an unsaturated carboxylic acid with an aliphatic polyhydric alcohol compound and an amide of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used. Furthermore, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

With respect to specific examples of the monomer, which is an ester of an aliphatic polyhydric alcohol compound with an unsaturated carboxylic acid, as an acrylic acid ester, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethyleneoxide (EO)-modified triacrylate, polyester acrylate oligomer or isocyanuric acid EO-modified triacrylate is exemplified.

As a methacrylic acid ester, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3 -methacryloxy-2-hydroxypropoxy)phenyl]dimethylmethane or bis[p-(methacryloxyethoxy)phenyl]dimethylmethane is exemplified.

As an itaconic acid ester, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate is exemplified. As a crotonic acid ester, for example, ethylene glycol dicrotonate, tetramethylene glycol dicrotonate, pentaerythritol dicrotonate and sorbitol tetracrotonate is exemplified. As an isocrotonic acid ester, for example, ethylene glycol diisocrotonate, pentaerythritol diisocrotonate and sorbitol tetraisocrotonate is exemplified. As a maleic acid ester, for example, ethylene glycol dimaleate, triethylene glycol dimaleate, pentaerythritol dimaleate or sorbitol tetramaleate is exemplified.

Other examples of the ester, which can be preferably used, include aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613. Further, the above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

Urethane type addition polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (b) shown below to a polyisocyanate compound having two or more isocyanate groups per molecule, described in JP-B-48-41708.

CH₂=C(R₄)COOCH₂CH(R₅)OH (b)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Furthermore, a photopolymerizable composition having remarkably excellent photosensitive speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid compounds described in JP-A-2-25493 can also be exemplified. In some cases, structure containing a perfluoroalkyl group described in JP-A-61-22048 can be preferably used. Moreover, photocurable monomers or oligomers described in Journal of Japan Adhesion Society, Vol. 20, No. 7, pages 300 to 308 (1984) can also be used.

Details of the method of using the polymerizable compound, for example, selection of the structure, individual or combination use, or an amount added, can be appropriately arranged depending on the characteristic design of the final lithographic printing plate precursor. For instance, the compound is selected from the following standpoints.

In view of the sensitivity, a structure having a large content of unsaturated groups per molecule is preferred and in many cases, a bifunctional or more functional compound is preferred. In order to increase the strength of image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the image-recording layer. For instance, the compatibility may be improved in some cases by using the compound of low purity or using two or more kinds of the compounds in combination. A specific structure may be selected for the purpose of improving an adhesion property, for example, to a support or a protective layer described below.

The polymerizable compound is preferably used in a range from 5 to 80% by weight, more preferably from 25 to 75% by weight in the image-recording layer. The polymerizable compounds may be used individually or in combination of two or more thereof. In the method of using the polymerizable compound, the structure, blend and amount added can be appropriately selected by taking account of the extent of polymerization inhibition due to oxygen, resolution, fogging property, change in refractive index, surface tackiness and the like. Further, depending on the case, a layer construction, for example, an undercoat layer or an overcoat layer, and a coating method, may also be considered.

### (Color-forming compound)

The color-forming agent which can be used in the invention includes an acid color-forming agent and a heat color-forming agent. In the case of using a cyanine dye as the infrared absorbing agent, the cyanine dye also functions as the color-forming compound, because it forms color in the visible range by exposure. It is also possible to use the cyanine dye together with the acid color-forming agent or the heat color-forming agent in the invention. The combination use more improves the print-out property.

### (1) Acid color-forming agent

As the acid color-forming agent which can be used in the invention, any compound which causes color formation (change from colorless to color) due to an action of acid may be preferably used. Examples of the dye include a triarylmethane compound, a biphenylmethane compound, a xanthene compound, a fluoran compound, a thiazine compound, a spiropyran compound and compounds described in JP-A-2001-277730. Of the compounds, a triarylmethane compound, a xanthene compound, a fluoran compound, a spiropyran compound and compounds described in JP-A-2001-277730 are particularly preferred. Examples of the acid color-forming agent are set forth below, but the invention should not be construed as being limited thereto.

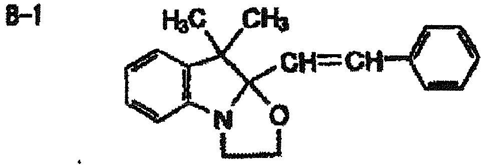

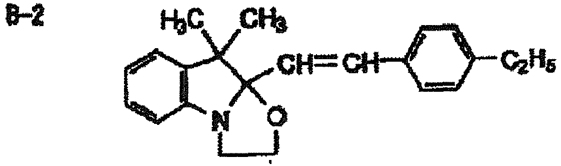

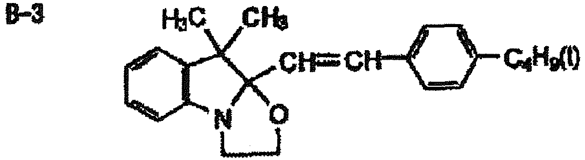

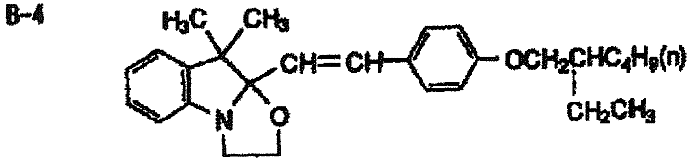

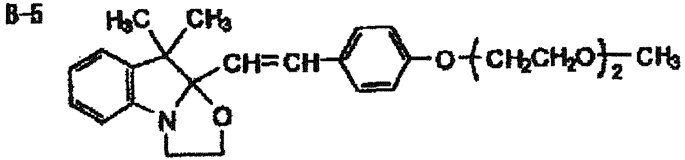

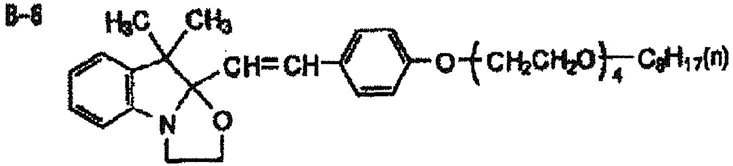

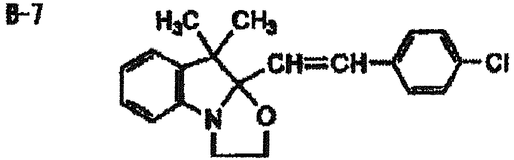

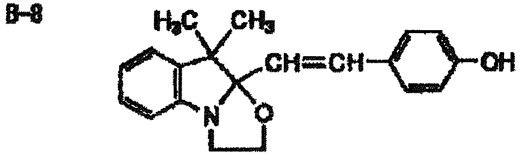

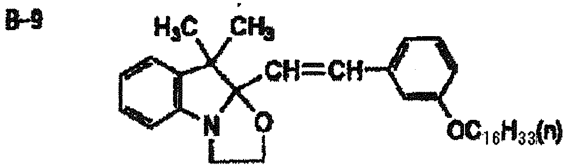

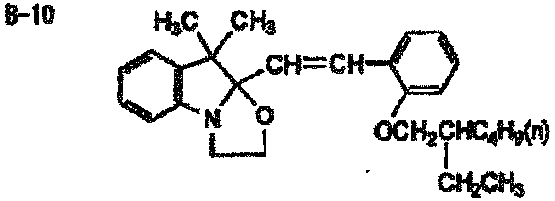

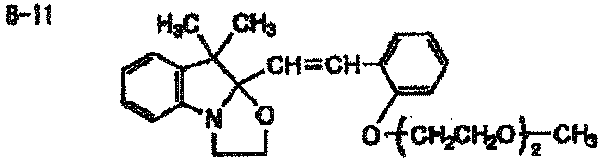

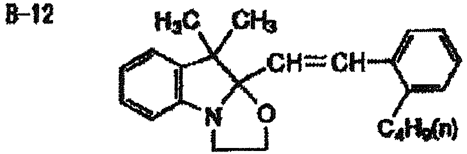

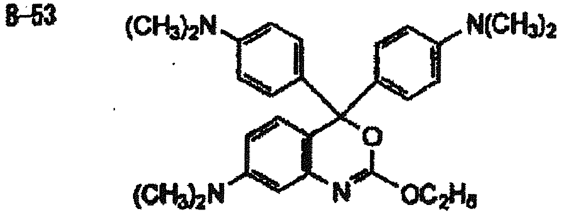

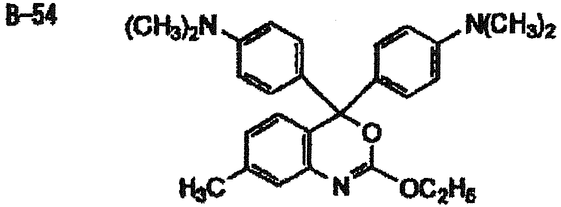

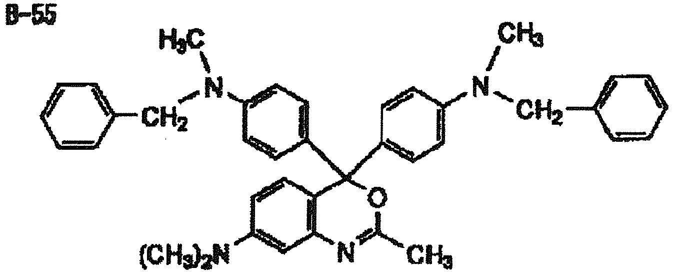

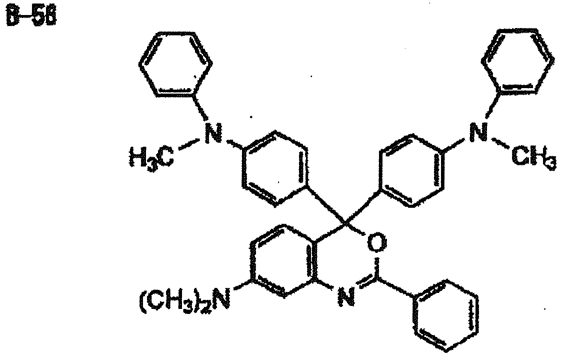

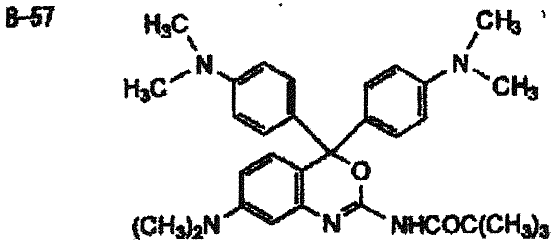

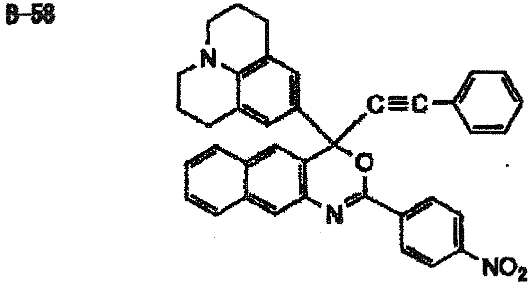

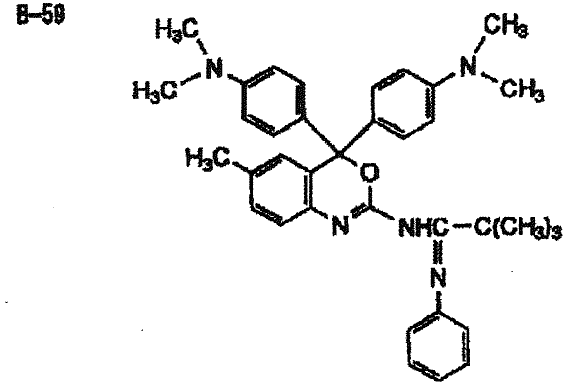

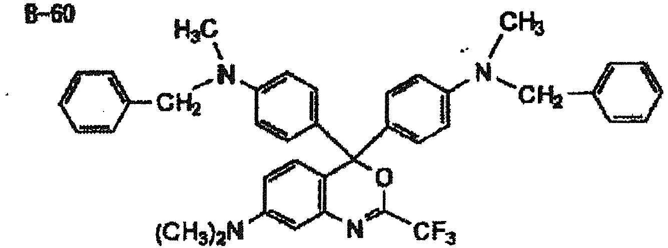

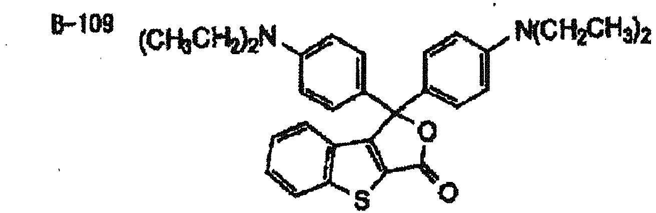

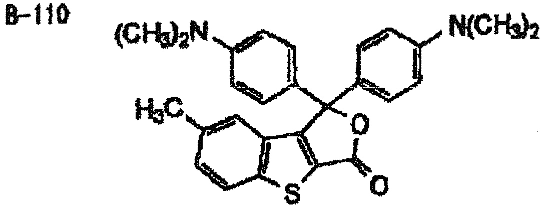

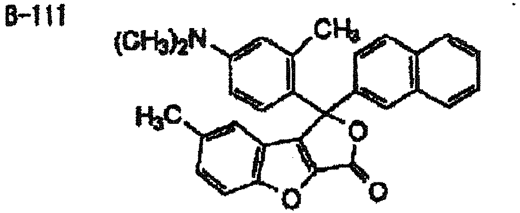

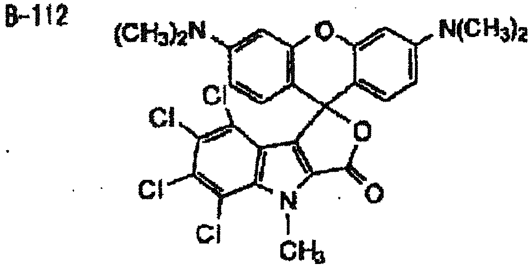

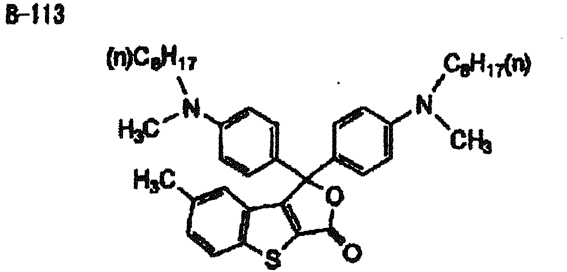

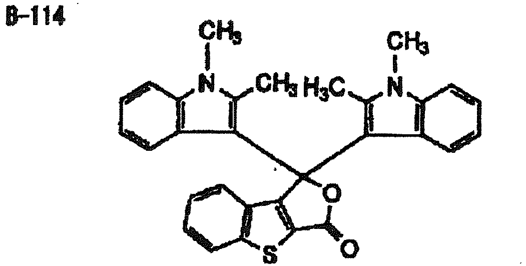

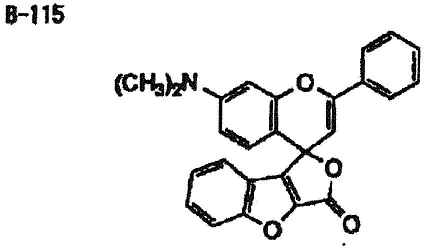

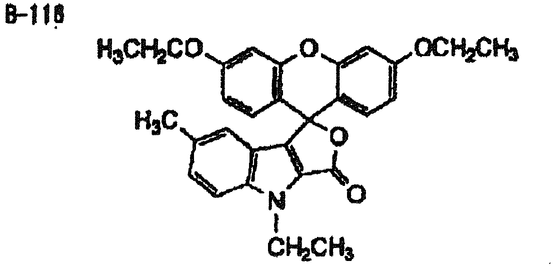

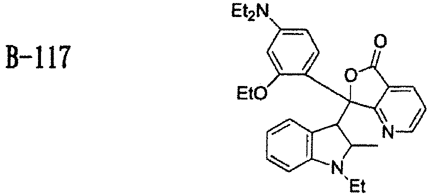

The amount of the acid color-forming agent added is preferably from 0.01 to 0.5 g/m², more preferably from 0.02 to 0.2 g/m², and particularly preferably from 0.03 to 0.1 g/m².

### (2) Heat color-forming agent

As the heat color-forming agent which can be used in the invention, any compound which causes color formation (change from colorless to color) due to an action of heat may be preferably used. Examples of the dye include a spiropyran compound, a condensed aromatic ring-substituted ethylene derivative, for example, an anthrone compound, a polythiophene derivative, a liquid crystal, for example, a cholesteric liquid crystal, and METHAMOCOLOR (registered trademark, produced by The Pilot Pen Co., Ltd.), which is a thermochromic material causing based on an electron donating and accepting mechanism at a thermal equilibrium of a polar compound of electron donor and electron acceptor. The invention should not be construed as being limited thereto.

Specific examples of the heat color-forming agent preferably used in the invention are set forth below, but the invention should not be construed as being limited thereto.

### Spiropyrans

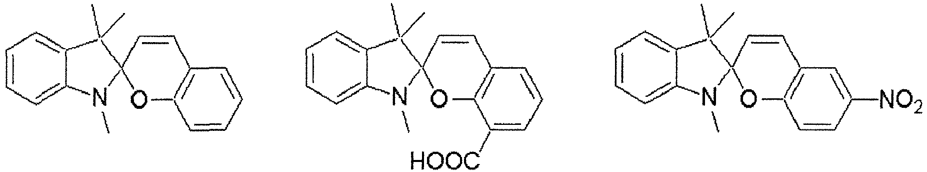

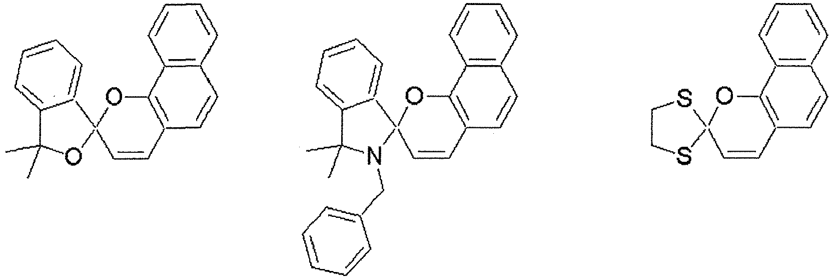

### Spirooxazines

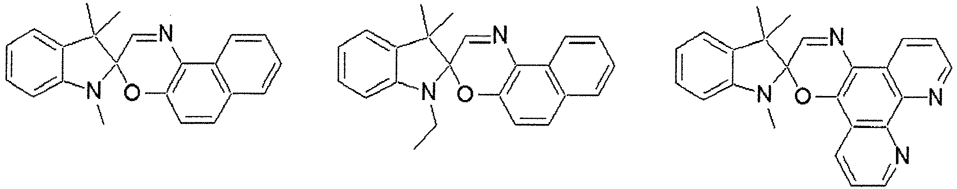

### Salicyl Schiff bases

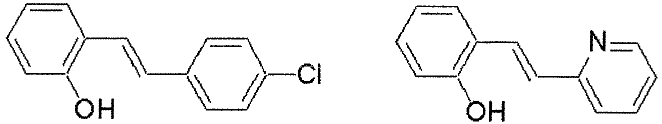

### Bianthrones

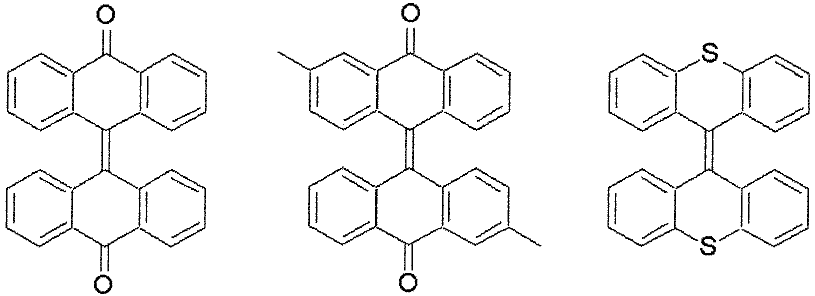

### Polytiophenes

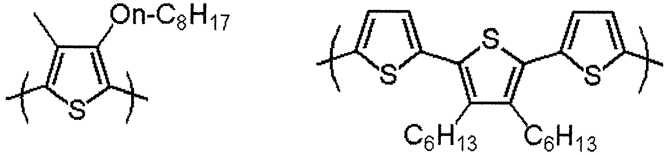

### Diazaanthracenophanes

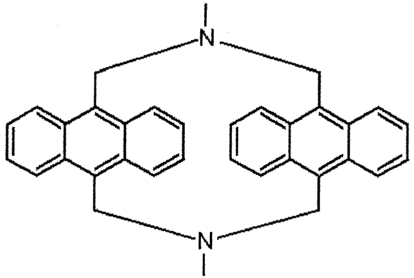

### Polyacetylenes

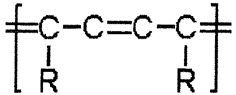

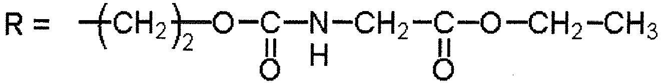

The amount of the heat color-forming agent added is preferably from 0.01 to 0.5 g/m², more preferably from 0.02 to 0.2 g/m², and particularly preferably from 0.03 to 0.1 g/m².

### (Other Compounds)

### (1) Borate compound

The image-recording layer according to the invention preferably contains a borate compound. By incorporating the borate compound into the image-recording layer, color-forming property of the heat or acid color-forming agent can be increased. The borate compound which can be used in the invention is not particularly limited as long as it has a boron anion structure, and is preferably a borate compound having a structure represented by formula (c) shown below.

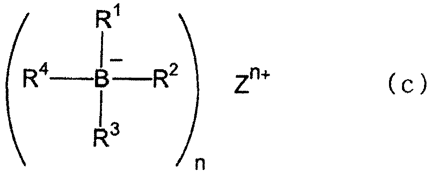

In formula (c), R¹ to R⁴ each independently represents a monovalent organic group, Zⁿ⁺ represents an n-valent cation, and n represents an integer from 1 to 6.

The monovalent organic group represented by any of R¹ to R⁴ includes, for example, an alkyl group, an alkenyl group, an aryl group, an alkynyl group and a cycloalkyl group, and is preferably an aryl group. The monovalent organic group may have a substituent and examples of the substituent capable of being introduced include an alkyl group, a halogenated alkyl group, an alkenyl group, an alkynyl group, an aryl group, a halogen atom, an alkoxy group, an alkoxycarbonyl group, an amino group, a cyano group, an amido group, a urethane group, a sulfo group, a thioalkoxy group and a carboxyl group.

Of the compounds, compounds wherein R¹ to R⁴ each represents an aryl group are preferred, and the aryl group is more preferably an aryl group having an electron withdrawing group as the substituent. R¹ to R⁴ may be the same or different from each other.

The electron withdrawing group introduced into the aryl group is preferably a halogen atom or a fluoroalkyl group, and particularly preferably a fluorine atom or a trifluoromethyl group.

Zⁿ⁺ may be used without limitation as long as it is a cation capable of neutralizing the borate anion. Examples of the cation preferably used include an alkali metal ion, an alkaline earth metal ion and an onium salt, for example, a sulfonium salt, an iodonium salt, an azinium salt, an ammonium salt, a phosphonium salt or a diazonium salt. From the standpoint of development property, an alkali metal ion, for example, Li, Na or K is preferred.

Examples of the borate compound preferably used in the invention are set forth below, but the invention should not be construed as being limited thereto.

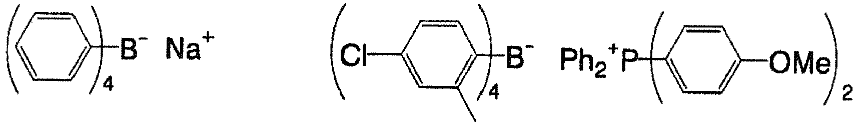

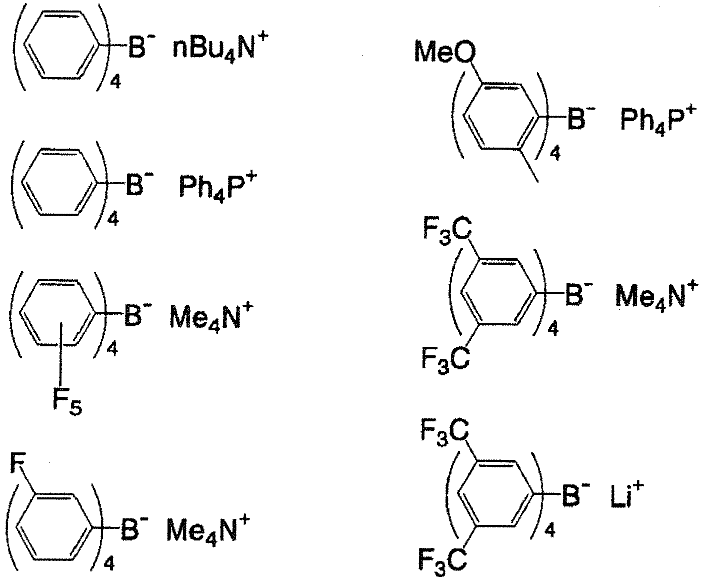

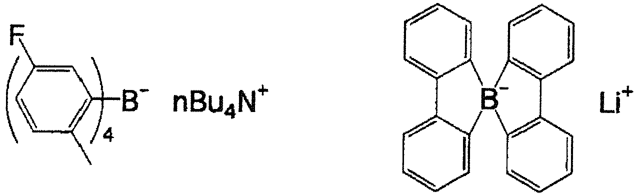

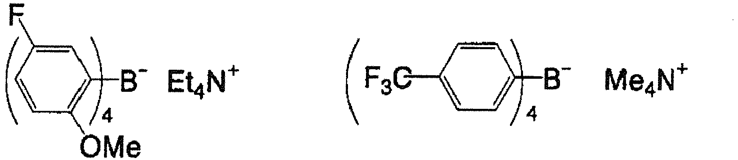

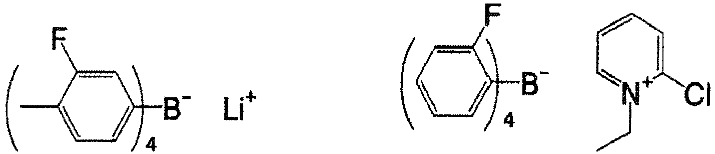

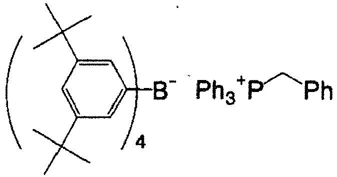

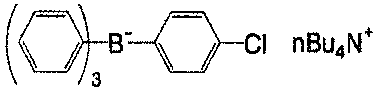

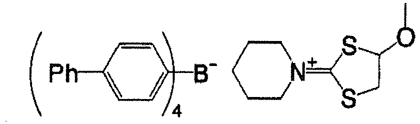

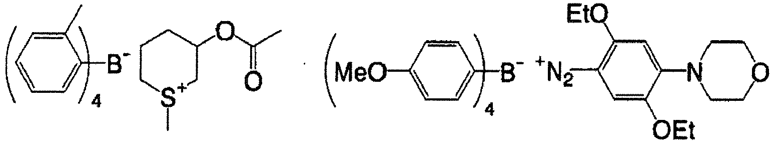

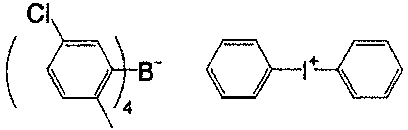

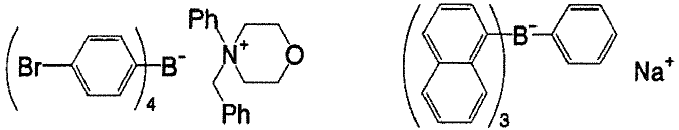

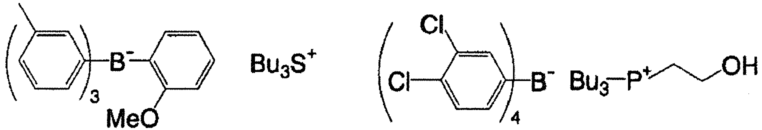

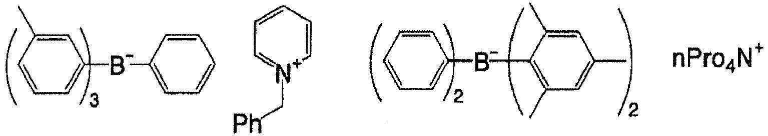

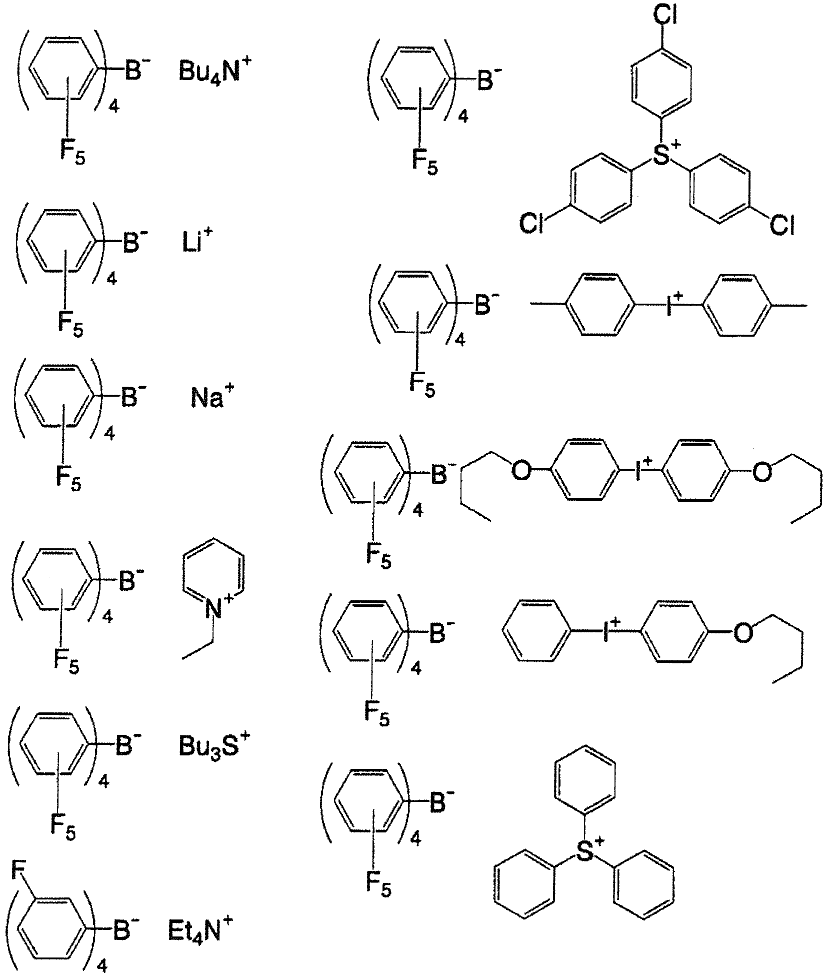

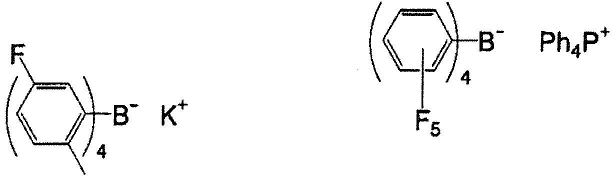

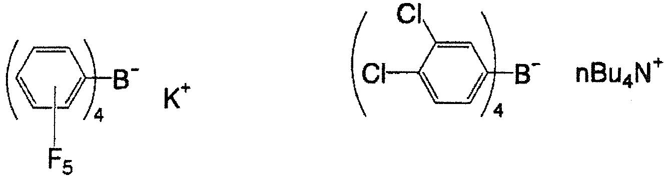

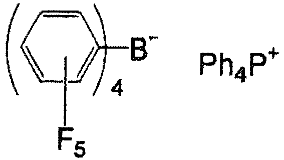

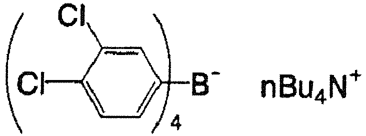

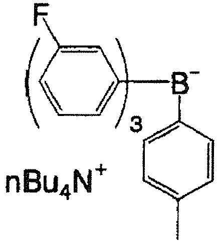

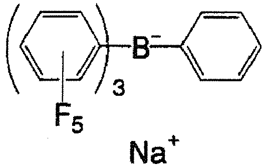

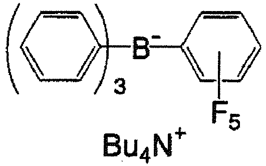

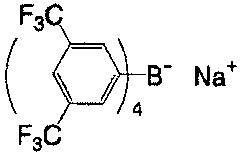

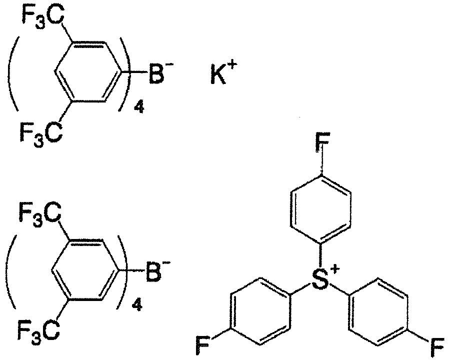

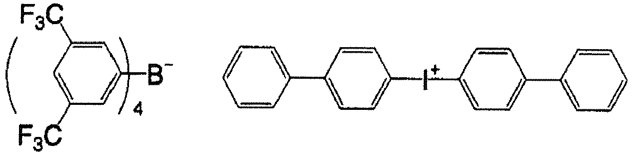

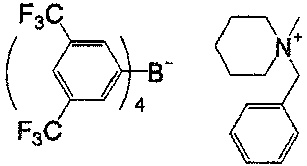

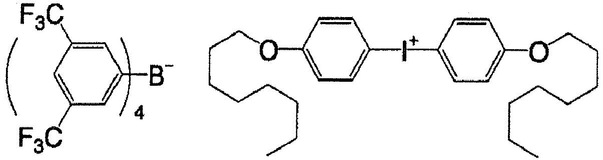

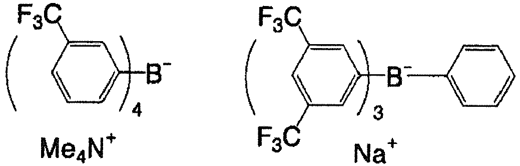

Of the borate compounds, a tetraphenyl borate is most preferred.

The content of the borate compound in the image-recording layer according to the invention is preferably from 0.1 to 20% by weight, more preferably from 1 to 10% by weight, calculated in terms of solid content, from the standpoint of printing-out property.

### (2) Binder polymer

In the image-recording layer according to the invention, a binder polymer can be used for the purpose of improving film strength of the image-recording layer. The binder polymer which can be used in the invention can be selected from those heretofore known without limitation, and a polymer having a film-forming property is preferred. Among them, an acrylic resin, a polyvinyl acetal resin or a polyurethane resin is preferred.

As the binder polymer preferred for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group or an allyl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable functional group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the on-press development property to the image-recording layer. In particular, coexistence of the crosslinkable functional group and the hydrophilic group makes it possible to maintain compatibility between the printing durability and on-press development property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units each having 2 or 3 carbon atoms is preferred. In particular, a polyethylene oxide structure containing from 2 to 8 ethylene oxide units is preferred. In order to introduce a hydrophilic group into the binder polymer, a monomer having the hydrophilic group may be copolymerized.

In order to control the ink receptivity, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate may be copolymerized.

Specific examples (1) to (11) of the binder polymer for use in the invention are set forth below, but the invention should not be construed as being limited thereto. The ratio of the repeating units is indicated as a molar ratio.

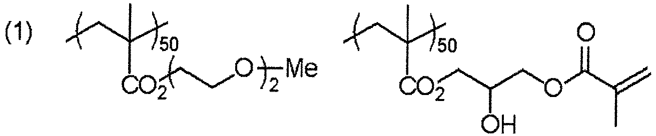

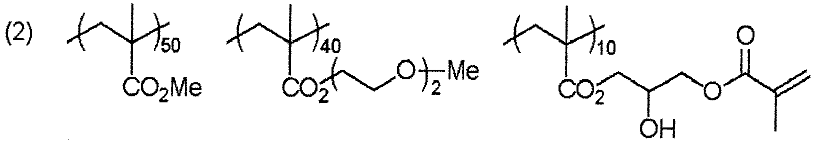

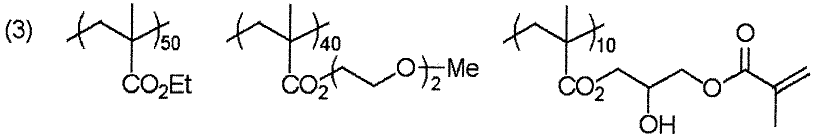

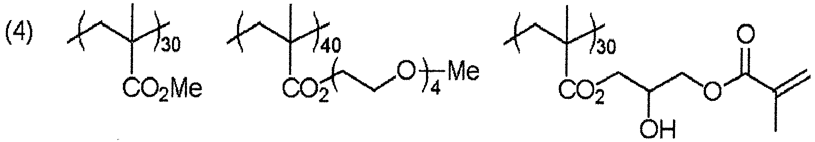

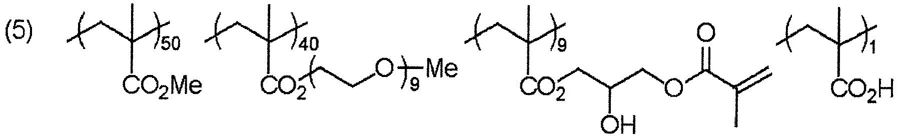

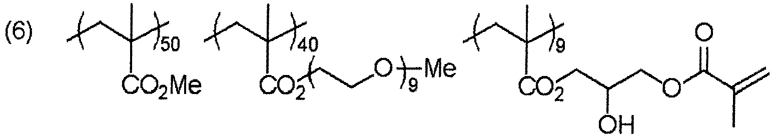

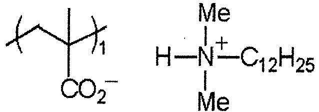

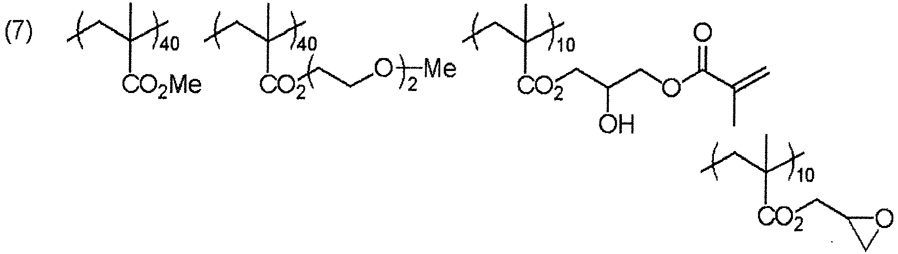

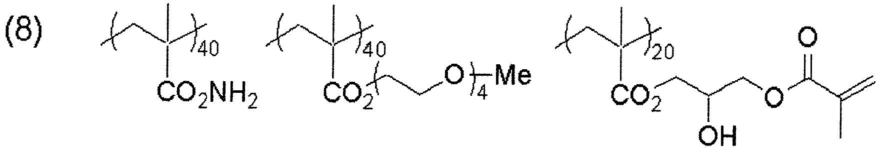

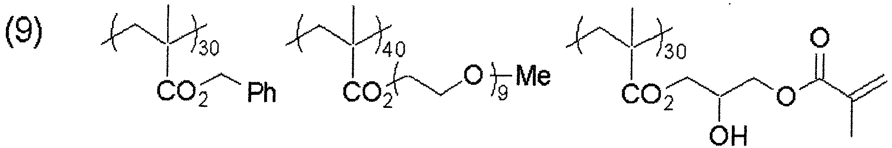

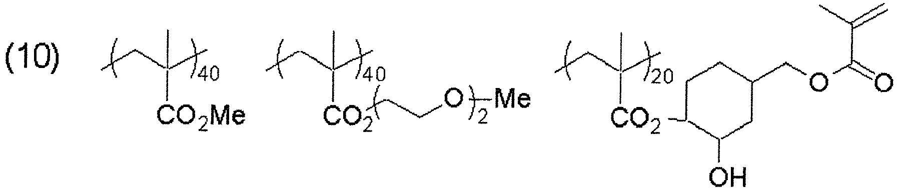

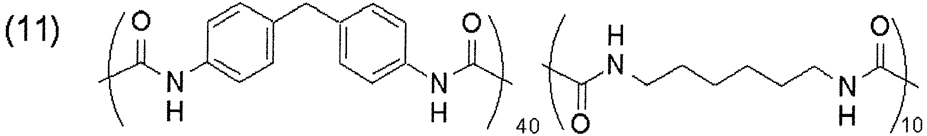

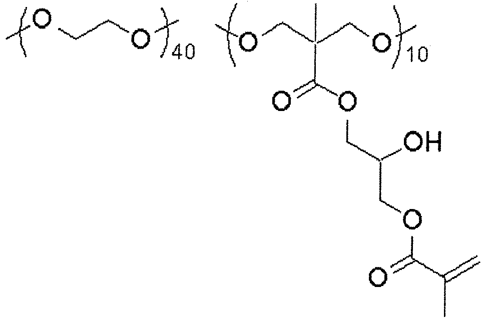

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is ordinarily from 5 to 90% by weight, preferably from 5 to 80% by weight, more preferably from 10 to 70% by weight, based on the total solid content of the image-recording layer.

### (3) Polymer fine particle

According to the invention, a polymer fine particle can be used in the image-recording layer in order to improve the on-press development property. A polymer fine particle having a polyalkylene oxide structure is preferred. In particular, a polymer fine particle having a polyalkylene oxide group in its side chain is preferred. By using the polymer fine particle, permeability of dampening water increases, thereby improving the on-press development property.

The polymer fine particle according to the invention is preferably a hydrophobizing precursor capable of converting the image-recording layer to be hydrophobic when heat is applied. The hydrophobizing precursor polymer fine particle is preferably at least one fine particle selected from a hydrophobic thermoplastic polymer fine particle, a thermo-reactive polymer fine particle, a microcapsule having a hydrophobic compound encapsulated therein and a microgel (crosslinked polymer fine particle). Among them, a polymer fine particle having a polymerizable group and a microgel are preferred. In order to improve the on-press development property, the polymer fine particle preferably contains a polyalkylene oxide structure as described above.

As the hydrophobic thermoplastic polymer fine particle, hydrophobic thermoplastic polymer fine particles described, for example, in Research Disclosure, No. 333003, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is preferred.

The average particle size of the hydrophobic thermoplastic polymer fine particle which can be used in the invention is preferably from 0.01 to 2.0 µm.

The thermo-reactive polymer fine particle which can be used in the invention includes a polymer fine particle having a thermo-reactive group and forms a hydrophobized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxy group or an amino group as the reaction partner thereof, and an acid anhydride performing a ring opening addition reaction and an amino group or a hydroxy group as the reaction partner thereof are preferably exemplified.

As the microcapsule for use in the invention, microcapsule having all or part of the constituting components of the image-recording layer encapsulated therein as described, for example, in JP-A-2001-277740 and JP-A-2001-277742 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel may contain a part of the constituting components of the image-recording layer at least in the inside and on the surface thereof. Particularly, an embodiment of a reactive microgel containing the polymerizable compound on the surface thereof is preferred from the standpoint of the image-forming sensitivity and printing durability.

As a method of microencapsulation or microgelation of the constituting components of the image-recording layer, known methods can be used.

The average particle size of the microcapsule or microgel is preferably from 0.01 to 3.0 µm, more preferably from 0.05 to 2.0 µm, and particularly preferably from 0.10 to 1.0 µm. In the range described above, good resolution and good time-lapse stability can be achieved.

The content of the polymer fine particle is preferably from 5 to 90% by weight based on the total solid content of the image-recording layer.

### (4) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyol, e.g., glycerol, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; and an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphthalenedisulfonate or trisodium 1,3,6-naphthalenetrisulfonate; compounds described in Paragraph Nos. [0026] to [0031] of JP-A-2007-276454 and Paragraph Nos. [0020] to [0047] of JP-A-2009-154525. The salt may also be a potassium salt or a lithium salt.

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt. Specific examples of the organic sulfate include compounds described in Paragraph Nos. [0034] to [0038] of JP-A-2007-276454.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added is preferably from 0.5 to 20% by weight, more preferably from 1 to 15% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

### (5) Oil-sensitizing agent

In order to improve the ink receptivity, an oil-sensitizing agent, for example, a phosphonium compound, a nitrogen-containing low molecular weight compound or an ammonium group-containing polymer may be incorporated into the image-recording layer according to the invention. In particular, in the case where an inorganic stratiform compound is incorporated into a protective layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples of the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples of the ammonium group-containing polymer include polymers described in Paragraph Nos. [0089] to [0105] of JP-A-2009-208458.

Specific examples of the ammonium group-containing polymer are set forth below.
(1) 2-(Trimethylammonio)ethyl methacrylate p-toluenesulfonate/3,6-dioxaheptyl methacrylate copolymer (molar ratio: 10/90, Mw: 45,000)
(2) 2-(Trimethylammonio)ethyl methacrylate hexafluorophosphate /3,6-dioxaheptyl methacrylate copolymer (molar ratio: 20/80, Mw: 60,000)
(3) 2-(Ethyldimethylammonio)ethyl methacrylate p-toluenesulfonate/hexyl methacrylate copolymer (molar ratio: 30/70, Mw: 45,000)
(4) 2-(Trimethylammonio)ethyl methacrylate hexafluorophosphate /2-ethylhexyl methacrylate copolymer (molar ratio: 20/80, Mw: 60,000)
(5) 2-(Trimethylammonio)ethyl methacrylate methylsulfate/hexyl methacrylate copolymer (molar ratio: 40/60, Mw: 70,000)
(6) 2-(Butyldimethylammonio)ethyl methacrylate hexafluorophosphate/3,6-dioxaheptyl methacrylate copolymer (molar ratio: 25/75, Mw: 65,000)
(7) 2-(Butyldimethylammonio)ethyl acrylate hexafluorophosphate/3,6-dioxaheptyl methacrylate copolymer (molar ratio: 20/80, Mw: 65,000)
(8) 2-(Butyldimethylammonio)ethyl methacrylate
   13-ethyl-5,8,11-trioxa-1-heptadecanesulfonate/3,6-dioxaheptyl methacrylate copolymer (molar ratio: 20/80, Mw: 75,000)
(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, Mw: 65,000)

As to the ammonium group-containing polymer, its reduced specific viscosity value (unit: ml/g) determined according to the measuring method described in JP-2009-208458 is preferably from 5 to 120, more preferably from 10 to 110, particularly preferably from 15 to 100. When the reduced specific viscosity value described above is calculated in terms of weight average molecular weight (Mw), from 10,000 to 150,000 is preferred, from 17,000 to 140,000 is more preferred, and 20,000 to 130,000 is particularly preferred.

The content of the oil-sensitizing agent is preferably from 0.01 to 30.0% by weight, more preferably from 0.1 to 15.0% by weight, still more preferably from 1 to 10% by weight, based on the total solid content of the image-recording layer.

### (6) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

### [Formation of image-recording layer]

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose, but is in general preferably from 0.3 to 3.0 g/m², more preferably from 0.5 to 2.0 g/m², and most preferably from 0.8 to 1.5 g/m².

### [Undercoat layer]

In the lithographic printing plate precursor according to the invention, an undercoat layer may be provided between the white substrate and image-recording layer. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

The compound for use in the undercoat layer preferably includes a compound having a functional group capable of interacting with the surface of aluminum support and, in order to increase an adhesion property to the image-recording layer, a crosslinkable group, particularly a group having an ethylenically unsaturated bond. Further, a compound having a hydrophilicity-imparting group, for example, a sulfo group is also preferably exemplified. Such a compound may be a low molecular weight compound or a polymer compound. Also, such compounds may be used as a mixture of two or more thereof.

In the case of using the polymer, a copolymer of a monomer having a functional group capable of interacting with the surface of aluminum support, a monomer having an ethylenically unsaturated bond in its side chain and a monomer having a hydrophilic group is preferred. Examples of the polymer include the specific copolymer used in the white layer described above.

The undercoat layer according to the invention may contain a chelating agent, a secondary or tertiary amine, a polymerization inhibitor or a compound containing an amino group or a functional group having polymerization inhibition ability and a group capable of interacting with the surface of aluminum support (for example, 1,4-diazobicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid).

The undercoat layer is coated according to a known method. The coating amount (solid content) of the undercoat layer is preferably from 0.1 to 100 mg/m2, and more preferably from 1 to 30 mg/m².

### [Protective layer]

In the lithographic printing plate precursor according to the invention, a protective layer may be preferably provided on the image-recording layer, in order to prevent diffusion and penetration of oxygen which inhibits the polymerization reaction at the time of exposure. As a material which can be used in the protective layer, any water-soluble polymer and water-insoluble polymer may be appropriately selected to use. The polymers may be used as a mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Of the polymers, a water-soluble polymer relatively excellent in crystallizability is preferably used. Specifically, when polyvinyl alcohol is used as the main component, most preferred results are obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree in a range from 69.0 to 100% by mole and a polymerization repeating unit number in a range from 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). Polyvinyl alcohols can be used individually or as a mixture. The content of polyvinyl alcohol in the protective layer is preferably from 20 to 95% by weight, and more preferably from 30 to 90% by weight.

Also, a modified polyvinyl alcohol can be preferably used. Particularly, an acid-modified polyvinyl alcohol having a carboxylic acid group or a sulfonic acid group is preferably used. Specifically, polyvinyl alcohols described in JP-A-2005-250216 and JP-A-2006-259137 are preferably exemplified.

In the case of using other material as a mixture with polyvinyl alcohol, the material mixed with polyvinyl alcohol is preferably a modified polyvinyl alcohol, polyvinyl pyrrolidone or a modified product thereof from the standpoint of the oxygen-blocking property and removability by development. The content thereof is preferably from 3.5 to 80% by weight, more preferably from 10 to 60% by weight, still more preferably from 15 to 30% by weight, in the protective layer.

As other component of the protective layer, glycerol, dipropylene glycol or the like can be added in an amount of several % by weight of the (co)polymer to provide flexibility. Further, an anionic surfactant, for example, sodium alkylsulfate or sodium alkylsulfonate, an amphoteric surfactant, for example, alkylaminocarboxylate or alkylaminodicarboxylate, or a nonionic surfactant, for example, polyoxyethylene alkyl phenyl ether can be added in an amount of several % by weight of the (co)polymer.

Further, it is also preferred to incorporate an inorganic stratiform compound into the protective layer according to the invention for the purpose of increasing the oxygen-blocking property and property for protecting the surface of image-recording layer. Of the inorganic stratiform compounds, fluorine-based swellable synthetic mica, which is a synthetic inorganic stratiform compound, is particularly preferred. Specifically, inorganic stratiform compounds described in JP-A-2005-119273 are exemplified.

Moreover, protective layers described in U.S. Patent 3,458,311, JP-B-55-49729, JP-A-2008-15503, JP-A-2008-89916 and Paragraph Nos. [0211] to [0261] of JP-A-2008-139813 are also preferably used.

The coating amount of the protective layer is preferably from 0.05 to 10 g/m² in terms of the coating amount after drying. The coating amount is more preferably from 0.1 to 5 g/m² in the case where the protective layer contains the inorganic stratiform compound, and it is more preferably from 0.5 to 5 g/m² in the case where the protective layer does not contain the inorganic stratiform compound.

### [Printing method]

Plate making of the lithographic printing plate precursor according to the invention is preferably performed by an on-press development method. The plate making according to the on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the image-recording layer of the lithographic printing plate precursor is removed in the course of the printing step.
The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is performed. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.

The on-press development method is described in more detail below.

As the light source used for the image exposure in the invention, a laser is preferred. The laser for use in the invention is not particularly limited and preferably includes, for example, a solid laser or semiconductor laser emitting an infrared ray having a wavelength of 760 to 1,200 nm.

With respect to the infrared ray laser, the output is preferably 100 mW or more, the exposure time per pixel is preferably within 20 microseconds, and the irradiation energy amount is preferably from 10 to 300 mJ/cm². With respect to the laser exposure, in order to shorten the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the image exposure.

When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres on the revealed hydrophilic surface and the printing ink adheres to the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

### EXAMPLES

The invention will be described in detail with reference to the examples, but the invention should not be construed as being limited thereto. With respect to a polymer compound, unless otherwise specified, a molecular weight of the polymer compound means a weight average molecular weight (Mw) and a ratio of repeating units is indicated as a mole percent.

### Example 1

### (1) Treatment of support: Condition 1

An aluminum plate (material: 1050) having a thickness of 0.3 mm was subjected to a degreasing treatment at 50°C for 30 seconds using a 10% by weight aqueous sodium aluminate solution in order to remove rolling oil remaining on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in a 25% by weight aqueous sodium hydroxide solution of 45°C for 9 seconds, washed with water, then immersed in 20% by weight nitric acid at 60°C for 20 seconds, and washed with water. The etching amount of the grained surface was about 3 g/m².

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was then subjected to an electrochemical roughening treatment in the same manner as in the nitric acid electrolytic solution above using as an electrolytic solution, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying. The plate was subjected to an anodizing treatment using as an electrolytic solution, 15% by weight sulfuric acid (containing 0.5% by weight of aluminum ion) at a current density of 15 A/dm² to form a direct current anodized film of 2.5 g/m², washed with water and dried, and further treated with a 2.5% by weight aqueous sodium silicate solution at 30°C for 10 seconds. The steepness degree a45 of the support was calculated from the surface configuration measured by AFM and found to be 52%. The reflection density was measured and found to be 0.41.

### (2) Formation of white layer

Sol-gel solution 1 shown below was coated on the surface of aluminum plate subjected to the surface treatment and dried by heating (at 100°C, for 10 minutes) to from a white layer containing a fluorescent whitening agent (Compound 1) in an inorganic hydrophilic matrix and having a dry coating amount of 0.2 g/m².

### <Sol-gel solution 1>

| | |
|---|---|
| Sol-gel preparation solution (1) having composition shown below | 4.7 g |
| Compound 1 having structure shown below | 0.64 g |
| Polyoxyethylene nonylphenyl ether (NONIPOL 100, produced by Sanyo Chemical Industries, Ltd.) | 0.025 g |
| Water | 15 g |
| Methanol | 5g |

### Compound 1

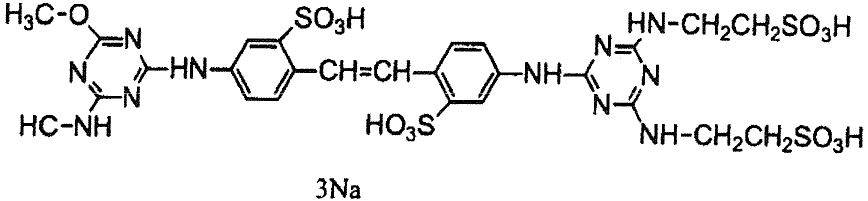

### (Production of Sol-gel preparation solution (1))

The composition shown below was ripened at room temperature for one hour to produce a sol-gel preparation solution.

| | |
|---|---|
| Tetraethoxysilane | 8.5 g |
| Methanol | 1.8 g |
| Water | 15.0 g |
| Phosphoric acid | 0.015 g |

### (3) Formation of image-forming layer

Coating solution 1 for image-forming layer having the composition shown below was coated on the support formed as described above by a bar and dried in an oven at 100°C for 60 seconds to form an image-forming layer having a dry coating amount of 1.0 g/m².

### <Coating solution 1 for image-forming layer>

| | |
|---|---|
| Binder polymer (1) having structure shown below | 0.240 g |
| Microgel (1) | 1.900 g |
| Infrared absorbing agent and Color-forming compound: Cyanine dye (1) having structure shown below | 0.015 g |
| Polymerization initiator (1) having structure shown below | 0.100 g |
| Polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium PF₆ salt) | 0.018 g |
| Oil-sensitizing agent (Ammonium group-containing polymer having structure shown below (reduced viscosity: 44 ml/g)) | 0.035 g |
| Fluorine-based surfactant (1) having structure shown below | 0.008 g |
| 2-Butanone | 1.091 g |
| 1-Methoxy-2-propanol | 8.609 g |

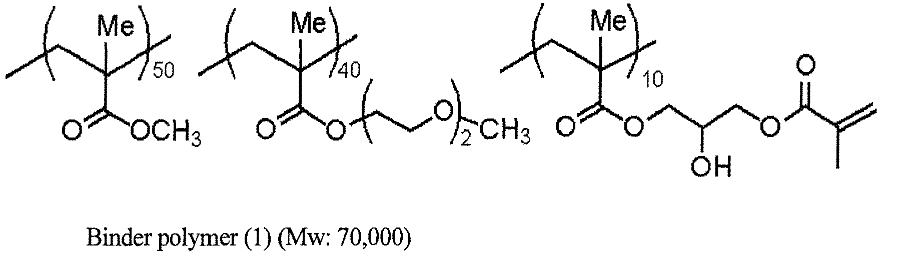

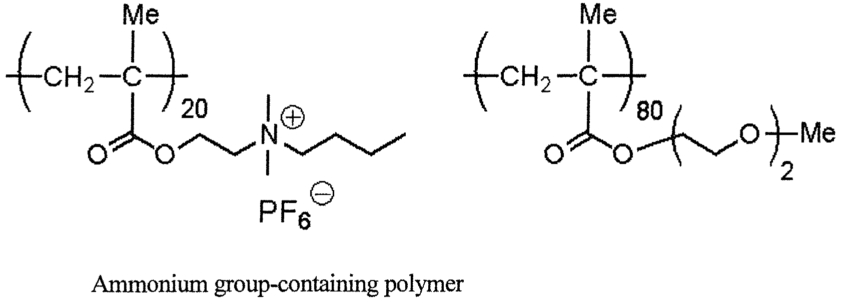

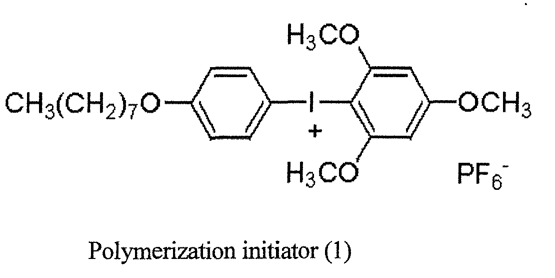

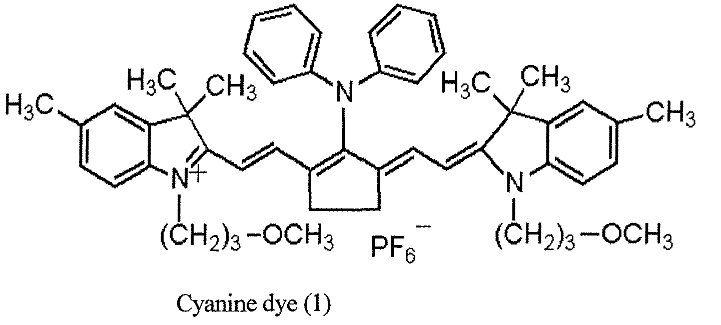

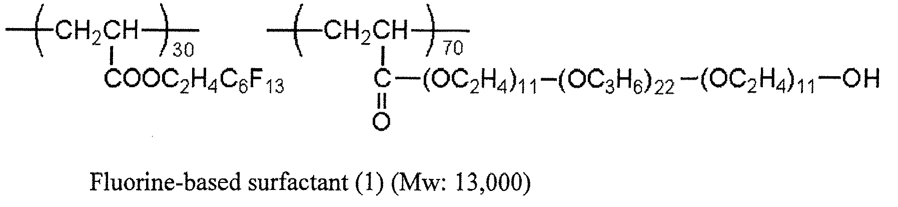

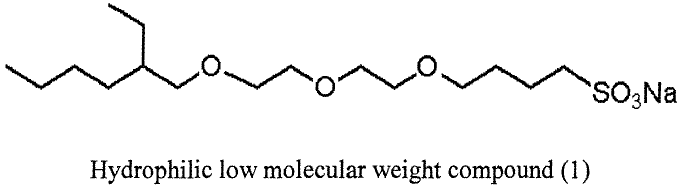

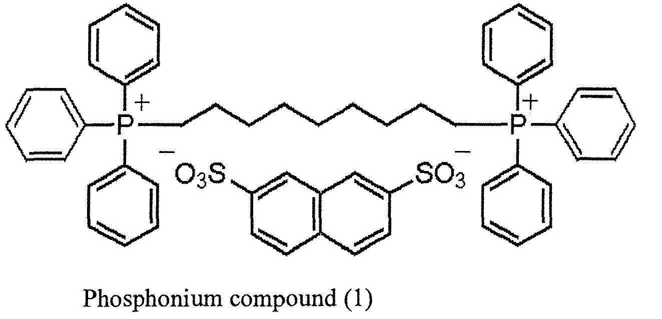

### Phosphonium compound (1)

### <Preparation of Microgel (1)>

An oil phase component was prepared by dissolving 10 g of an adduct of trimethylol propane and xylene diisocyanate (TAKENATE D-110N, produced by Mitsui Chemicals, Inc.), 3.15 g of pentaerythritol triacrylate (SR444, produced by Nippon Kayaku Co., Ltd.) and 0.1 g of PIONIN A-41C (produced by Takemoto Oil and Fat Co., Ltd.) in 17 g of ethyl acetate. As an aqueous phase component, 40 g of a 4% by weight aqueous solution of polyvinyl alcohol (PVA-205, produced by Kuraray Co., Ltd.) was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid concentration of 15% by weight to prepare Microgel (1). The average particle size of the microgel was measured by a light scattering method and found to be 0.2 µm.

### (4) Formation of protective layer

Coating solution (1) for protective layer having the composition shown below was coated on the image-forming layer by a bar and dried in an oven at 120°C for 60 seconds to form a protective layer having a dry coating amount of 0.15 g/m², thereby preparing a lithographic printing plate precursor.

### <Coating solution (1) for protective layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5% by mole, polymerization degree: 500, produced by Kuraray Co., Ltd.) | 0.03 g |
| Aqueous 1% by weight solution of surfactant (EMALEX 710, produced by Nihon Emulsion Co., Ltd. | 0.86 g |
| Ion-exchanged water | 6.0 g |

### (Preparation of Dispersion of inorganic stratiform compound (1))

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 µm. The aspect ratio of the particle thus-dispersed was 100 or more.

### Example 2

A lithographic printing plate precursor was produced in the same manner as in Example 1 except for changing the coating solution for image-forming layer to Coating solution 2 for image-forming layer.

### <Coating solution 2 for image-forming layer>

An acid color-forming agent was further added to Coating solution 1 for image-forming layer used in Example 1.

| | |
|---|---|
| Coating solution 1 for image-forming layer | 12.38 g |
| Acid color-forming agent having structure shown below | 0.1 g |

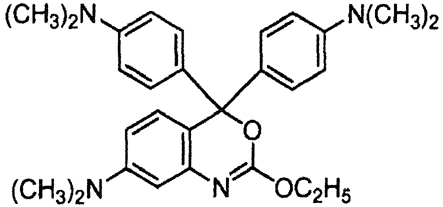

### Example 3

A lithographic printing plate precursor was produced in the same manner as in Example 1 except for changing the coating solution for image-forming layer to Coating solution 3 for image-forming layer.

### <Coating solution 3 for image-forming layer>

A heat color-forming agent was further added to Coating solution 1 for image-forming layer used in Example 1.

| | |
|---|---|
| Coating solution 1 for image-forming layer | 12.38 g |
| Heat color-forming agent having structure shown below | 0.1 g |

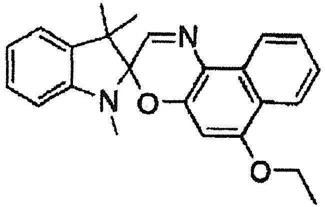

### Example 4

A lithographic printing plate precursor was produced in the same manner as in Example 1 except for changing the coating solution for image-forming layer to Coating solution 4 for image-forming layer.

### <Coating solution 4 for image-forming layer>

| | |
|---|---|
| Binder polymer (1) | 0.240 g |
| Microgel (1) | 1.900 g |
| Infrared absorbing agent and Color-forming compound: Cyanine dye (1) | 0.015 g |
| Polymerization initiator (2) having structure shown below | 0.100 g |
| Polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) | 0.050 g |
| Oil-sensitizing agent (Phosphonium compound (1)) | 0.055 g |
| Oil-sensitizing agent (Benzyl dimethyl octyl ammonium PF₆ salt) | 0.018 g |
| Oil-sensitizing agent (Ammonium group-containing polymer (reduced viscosity: 44 ml/g)) | 0.035 g |
| Fluorine-based surfactant (1) | 0.008 g |
| 2-Butanone | 1.091 g |
| 1 -Methoxy-2-propanol | 8.609 g |

### Polymerization initiator (2)

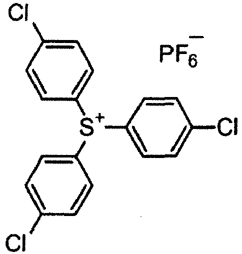

### Example 5

A lithographic printing plate precursor was produced in the same manner as in Example 1 except for changing the fluorescent whitening agent used in the formation of white layer to Compound 2 having the structure shown below.

### Compound 2

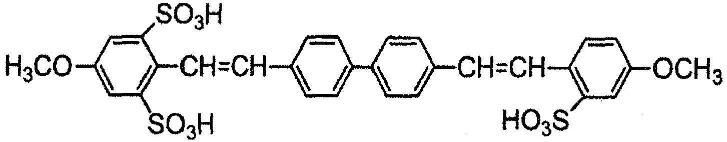

### Example 6

A lithographic printing plate precursor was produced in the same manner as in Example 1 except for changing the fluorescent whitening agent used in the formation of white layer to Compound 3 having the structure shown below.

### Compound 3

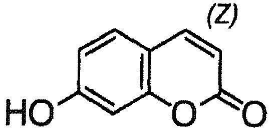

### Example 7

A lithographic printing plate precursor was produced in the same manner as in Example 1 except for changing the fluorescent whitening agent used in the formation of white layer to Compound 4 having the structure shown below.

### Compound 4

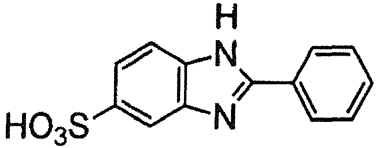

### Example 8

A lithographic printing plate precursor was produced in the same manner as in Example 1 except for using Sol-gel solution 2 in place of Sol-gel solution 1 in Example 1. A coating amount of the white layer containing the white pigment held in the inorganic hydrophilic matrix was set so that a dry weight of the white pigment was 0.5 g/m².

### <Sol-gel solution 2>

| | |
|---|---|
| Sol-gel preparation solution (1) | 4.7 g |
| Aqueous dispersion containing 20% by weight of titanium oxide and 10% by weight of polyvinyl alcohol (titanium oxide: rutile type, average particle side: 200 nm, produced by Wako Pure Chemical Industries, Ltd.; polyvinyl alcohol: PVA-117, produced by Kuraray Co., Ltd.) | 8 g |
| Methanol silica (colloid composed of methanol solution containing 30% by weight of silica particle of 10 to 20 nm, produced by Nissan Chemical Industries, Ltd.) | 8 g |
| Polyoxyethylene nonylphenyl ether (NONIPOL 100, produced by Sanyo Chemical Industries, Ltd.) | 0.025 g |
| Water | 15 g |
| Methanol | 5 g |

### Example 9

A lithographic printing plate precursor was produced in the same manner as in Example 1 except for using Sol-gel solution 3 in place of Sol-gel solution 1 in Example 1. In this case, the white layer containing the white pigment coated with Specific copolymer (1) having a group capable of interacting with the aluminum support and an ethylenically unsaturated bond group in the inorganic hydrophilic matrix was formed. The coating was conducted so that a dry weight of the white pigment was 0.5 g/m². Except the above, the lithographic printing plate precursor was produced in the same manner as in Example 1.

### <Sol-gel solution 3>

| | |
|---|---|
| Sol-gel preparation solution (1) | 4.7 g |
| Aqueous dispersion containing 20% by weight of titanium oxide and 10% by weight of Specific copolymer (1) (titanium oxide: rutile type, average particle side: 200 nm, produced by Wako Pure Chemical Industries) | 8 g |
| Methanol silica (colloid composed of methanol solution containing 30% by weight of silica particle of 10 to 20 nm, produced by Nissan Chemical Industries, Ltd.) | 8 g |
| Polyoxyethylene nonylphenyl ether (NONIPOL 100, produced by Sanyo Chemical Industries, Ltd.) | 0.025 g |
| Water | 15 g |
| Methanol | 5 g |

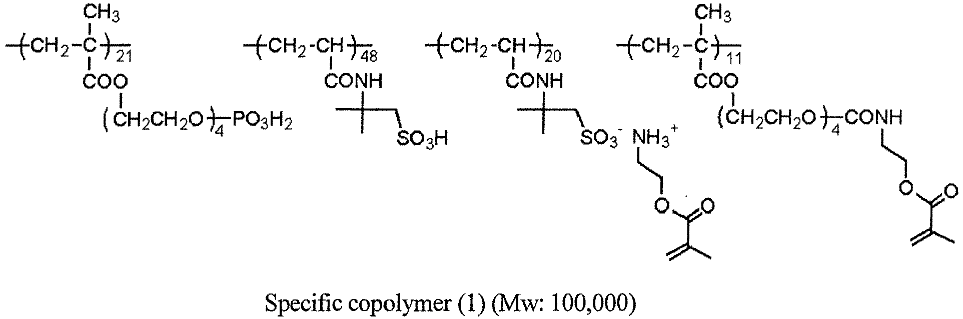

### Example 10

A lithographic printing plate precursor was produced in the same manner as in Example 9 except for changing the coating solution for image-forming layer to Coating solution 2 for image-forming layer.

### Example 11

A lithographic printing plate precursor was produced in the same manner as in Example 9 except for changing the coating solution for image-forming layer to Coating solution 3 for image-forming layer.

### Example 12

A lithographic printing plate precursor was produced in the same manner as in Example 11 except for changing Sol-gel solution 3 to Sol-gel solution 4 shown below. In this case, the white layer had a configuration of containing the white pigment coated with Specific copolymer (1) and the fluorescent whitening agent in the inorganic hydrophilic matrix. The coating amount was set so that a dry weight of the white pigment was 0.5 g/m² same as in Example 11.

### <Sol-gel solution 4>

| | |
|---|---|
| Sol-gel preparation solution (1) | 4.7 g |
| Aqueous dispersion containing 20% by weight of titanium oxide and 10% by weight of Specific copolymer (1) (titanium oxide: rutile type, average particle side: 200 nm, produced by Wako Pure Chemical Industries) | 4 g |
| Methanol silica (colloid composed of methanol solution containing 30% by weight of silica particle of 10 to 20 nm, produced by Nissan Chemical Industries, Ltd.) | 4 g |
| Compound 1 | 0.32 g |
| Polyoxyethylene nonylphenyl ether (NONIPOL 100, produced by Sanyo Chemical Industries, Ltd.) | 0.025 g |
| Water | 15 g |
| Methanol | 5 g |

### Example 13

### (1) Treatment of support: Condition 2

An aluminum plate (material: 1050) having a thickness of 0.3 mm was subjected to a degreasing treatment at 50°C for 30 seconds using a 10% by weight aqueous sodium aluminate solution in order to remove rolling oil remaining on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in a 25% by weight aqueous sodium hydroxide solution of 45°C for 9 seconds, washed with water, then immersed in 20% by weight nitric acid at 60°C for 20 seconds, and washed with water. The etching amount of the grained surface was about 3 g/m².

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was then subjected to an electrochemical roughening treatment in the same manner as in the nitric acid electrolytic solution above using as an electrolytic solution, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying.

An aqueous sodium hydroxide solution (sodium hydroxide concentration of 26% by weight) was applied to the surface of aluminum plate treated by spraying to dissolve the aluminum, thereby conducting an etching treatment. The temperature of the alkali etching treatment was 70°C.

Then, the plate was subjected to an anodizing treatment using as an electrolytic solution, 15% by weight sulfuric acid (containing 0.5% by weight of aluminum ion) at a current density of 15 A/dm² to form a direct current anodized film of 2.5 g/m², washed with water and dried, and further treated with a 2.5% by weight aqueous sodium silicate solution at 30°C for 10 seconds. The steepness degree a45 of the support was calculated from the surface configuration measured by AFM and found to be 28%.

### (2) Formation of image-forming layer

Coating solution 1 for image-forming layer described above was coated on the support formed as described above by a bar and dried in an oven at 100°C for 60 seconds to form an image-forming layer having a dry coating amount of 1.0 g/m², and the protective layer was provided in the same manner as in Example 1, thereby producing a lithographic printing plate precursor.

### Example 14

### (1) Treatment of support: Condition 3

The treatment of support was conducted in the same manner as in Example 13 except for changing the concentration of sodium hydroxide in the aqueous sodium hydroxide solution in Condition 2 of the treatment of support to 30% by weight and the aluminum ion concentration to 6% by weight. The steepness degree a45 of the support was calculated from the surface configuration measured by AFM and found to be 20%.

### (2) Formation of image-forming layer

The image-forming layer and the protective layer were provided on the support formed as described above in the same manner as in Example 13, thereby producing a lithographic printing plate precursor.

### Example 15

A lithographic printing plate precursor was produced in the same manner as in Example 14 except for changing the coating solution for image-forming layer to Coating solution 2 for image-forming layer.

### Example 16

A lithographic printing plate precursor was produced in the same manner as in Example 14 except for changing the coating solution for image-forming layer to Coating solution 3 for image-forming layer.

### Example 17

Coating solution 1 for undercoat layer shown below was coated on the support having the steepness degree a45 of 20% described in Example 14 so as to have a dry coating amount of 20 mg/m² to form an undercoat layer. Then, on the undercoat layer were provided the image-forming layer (Coating solution 1 for image-forming layer) and the protective layer in the same manner as in Example 14, thereby producing a lithographic printing plate precursor.

### <Coating solution 1 for undercoat layer>

| | |
|---|---|
| Specific copolymer (1) | 0.18 g |
| Hydroxyethyliminodiacetic acid | 0.10 g |
| Methanol | 55.24 g |
| Water | 6.15 g |

### Example 18

A lithographic printing plate precursor was produced in the same manner as in Example 14 except for changing the coating solution for image-forming layer to Coating solution 5 for image-forming layer.

### <Coating solution 5 for image-forming layer>

To Coating solution 1 for image-forming layer used in Example 1 were added a tetraphenyl borate and an acid color-forming agent. Specifically, the composition of Coating solution 5 for image-forming layer was as shown below.

| | |
|---|---|
| Coating solution 1 for image-forming layer | 12.38 g |
| Sodium tetraphenyl borate | 0.100 g |
| Acid color-forming agent | 0.1 g |

### Example 19

A lithographic printing plate precursor was produced in the same manner as in Example 14 except for changing the coating solution for image-forming layer to Coating solution 6 for image-forming layer shown below.

<Coating solution 6 for image-forming layer>

To Coating solution 1 for image-forming layer used in Example 1 were added a tetraphenyl borate and a heat color-forming agent. Specifically, the composition of Coating solution 6 for image-forming layer was as shown below.

| | |
|---|---|
| Coating solution 1 for image-forming layer | 12.38 g |
| Sodium tetraphenyl borate | 0.100 g |
| Heat color-forming agent | 0.1 g |

### Example 20

On the support having the steepness degree a45 of 20% described in Example 14 were formed the white layer, the image-forming layer and the protective layer in the same manner as in Example 12, thereby producing a lithographic printing plate precursor.

### Comparative Example 1

For comparison of Example 1, a lithographic printing plate precursor was produced in the same manner as in Example 1 except for eliminating the formation of white layer in the production of lithographic printing plate precursor in Example 1.

### Comparative Example 2

For comparison of Example 2, a lithographic printing plate precursor was produced in the same manner as in Example 2 except for eliminating the formation of white layer in the production of lithographic printing plate precursor in Example 2.

### Comparative Example 3

For comparison of Example 3, a lithographic printing plate precursor was produced in the same manner as in Example 3 except for eliminating the formation of white layer in the production of lithographic printing plate precursor in Example 3.

### Comparative Example 4

For comparison of Example 1, a lithographic printing plate precursor was produced wherein the white layer was not formed in the production of lithographic printing plate precursor in Example 1, the image-forming layer was formed with Coating solution 7 for image-forming layer shown below, and the protective layer same as in Example 1 was provided.

### <Coating solution 7 for image-forming layer>

| | |
|---|---|
| Coating solution 1 for image-forming layer | 12.38 g |
| Compound 1 | 0.100 g |

### Comparative Example 5

For comparison of Example 1, a lithographic printing plate precursor was produced in the same manner as in Example 1 except for changing the coating solution for the image-forming layer to Coating solution 8 for image-forming layer shown below in the production of lithographic printing plate precursor in Example 1.

### <Coating solution 8 for image-forming layer>

| | |
|---|---|
| Coating solution 1 for image-forming layer | 12.38 g |
| Methylene blue | 1.00 g |

### [Evaluation of lithographic printing plate precursor for Examples 1 to 20 and Comparative Examples 1 to 5]

### (Exposure)

The lithographic printing plate precursor was exposed by Trendsetter 3244VX (produced by Creo Co.) equipped with a water-cooled 40 W infrared semiconductor laser under the conditions of output of 11.7 W, a rotational number of an external drum of 250 rpm and resolution of 2,400 dpi. The exposed image contained a solid image area and a fine line chart.

### (Evaluation of print-out property: Measurement of ΔL)

As to ease of plate inspection of the exposed lithographic printing plate precursor, using the L value (luminance) of L*a*b* color system, a difference ΔL between the L value of the exposed area and the L value of the unexposed area was determined. As the value of ΔL is larger, it is meant that the print-out property (plate inspection property) is more excellent. The measurement was conducted according to SCE (specular competent exclude) system using a spectral colorimeter CM2600d and an operation soft CM-S100W each produced by Konica Minolta Holdings, Inc. According to the SCE system, since the specular light is excluded and only the diffusion light is measured, evaluation of color close to evaluation with visual observation is conducted and the result well correlates with the practical human plate inspection. The determinations of ΔL were conducted within 30 minutes after the exposure. The results are shown in Table 1.

### (Evaluation of printing)

The exposed lithographic printing plate precursor was mounted without undergoing development processing on a plate cylinder of a printing machine (LITHRONE 26, produced by Komori Corp.). Using dampening water (ECOLITY-2 (produced by Fujifilm Corp.)/tap water = 2/98 (volume ratio)) and FUSION-G (N) Black Ink (produced by DIC Graphics Corp.), the dampening water and the ink were supplied according to the standard automatic printing start method of LITHRONE 26 to conduct printing on 500 sheets of TOKUBISHI ART PAPER (76.5 kg) at a printing speed of 10,000 sheets per hour.

A number of the printing papers required until the on-press development of the unexposed area of the image-forming layer on the printing machine was completed to reach a state where the ink was not transferred to the printing paper in the non-image area was measured to evaluate the on-press development property. In the case of using any lithographic printing plate precursor, printed materials free from stain in the non-image area were obtained within 100 sheets.

### (Evaluation of safelight stability)

The exposed lithographic printing plate precursor was irradiated under a fluorescent lamp having illuminance of 800 lx for a certain period before mounting on the printing machine, and then the number of sheet for on-press development was determined under the same printing conditions as described above, thereby obtaining the fluorescent lamp irradiation time at which the deterioration of on-press development property occurred.

A case where the time at which the deterioration of on-press development property occurred is from 2 hours to less than 3 hours was evaluated that the safelight stability was B, and a case where the time at which the deterioration of on-press development property occurred is 3 hours or more was evaluated that the safelight stability was A. The results are shown in Table 1.

**TABLE 1**

| No. | White Substrate | | | | | | Undercoat Layer | |
|---|---|---|---|---|---|---|---|---|
| | Aluminum Support | | White Layer | | | Reflection Light Density | | |
| | | Steepness Degree a45 | Fluorescent Whitening Agent | White Pigment | Presence or Absence of Polymer | | | |
| Example 1 | Condition 1 | 52 | Compound 1 | Absence | Absence | 0.23 | Absence | |
| Example 2 | Condition 1 | 52 | Compound 1 | Absence | Absence | 0.23 | Absence | |
| Example 3 | Condition 1 | 52 | Compound 1 | Absence | Absence | 0.23 | Absence | |
| Example 4 | Condition 1 | 52 | Compound 1 | Absence | Absence | 0.23 | Absence | |
| Example 5 | Condition 1 | 52 | Compound 2 | Absence | Absence | 0.23 | Absence | |
| Example 6 | Condition 1 | 52 | Compound 3 | Absence | Absence | 0.24 | Absence | |
| Example 7 | Condition 1 | 52 | Compound 4 | Absence | Absence | 0.25 | Absence | |
| Example 8 | Condition 1 | 52 | Absence | Presence | PVA-117 by Kuraray | 0.20 | Absence | |
| Example 9 | Condition 1 | 52 | Absence | Presence | Specific Copolymer (1) | 0.20 | Absence | |
| Example 10 | Condition 1 | 52 | Absence | Presence | Specific Copolymer (1) | 0.20 | Absence | |
| Example 11 | Condition 1 | 52 | Absence | Presence | Specific Copolymer (1) | 0.20 | Absence | |
| Example 12 | Condition 1 | 52 | Compound 1 | Presence | Specific Copolymer (1) | 0.15 | Absence | |
| Example 13 | Condition 2 | 28 | Absence | Absence | Absence | 0.26 | Absence | |
| Example 14 | Condition 3 | 20 | Absence | Absence | Absence | 0.20 | Absence | |
| Example 15 | Condition 3 | 20 | Absence | Absence | Absence | 0.20 | Absence | |
| Example 16 | Condition 3 | 20 | Absence | Absence | Absence | 0.20 | Absence | |
| Example 17 | Condition 3 | 20 | Absence | Absence | Absence | 0.20 | Presence | |
| Example 18 | Condition 3 | 20 | Absence | Absence | Absence | 0.20 | Absence | |
| Example 19 | Condition 3 | 20 | Absence | Absence | Absence | 0.20 | Absence | |
| Example 20 | Condition 3 | 20 | Compound 1 | Presence | Specific Copolymer (1) | 0.10 | Absence | |
| Comparative Example 1 | Condition 1 | 52 | Absence | Absence | Absence | 0.41 | Absence | |
| Comparative Example 2 | Condition 1 | 52 | Absence | Absence | Absence | 0.41 | Absence | |
| Comparative Example 3 | Condition 1 | 52 | Absence | Absence | Absence | 0.41 | Absence | |
| Comparative Example 4 | Condition 1 | 52 | Absence | Absence | Absence | 0.41 | Absence | |
| Comparative Example 5 | Condition 1 | 52 | Compound 1 | Absence | Absence | 0.23 | Absence | |

| No. | Image-forming Layer | | | | | Reflection Light Density of Lithographic Printing Plate Precursor | Print-out Property | Safelight Stability |
|---|---|---|---|---|---|---|---|---|
| | | Infrared Absorbing Agent | Acid Color-forming Agent or Heat Color-forming Agent | Polymerization Initiator | Additive | | | |
| Example 1 | Coating Solution 1 for Image-forming Layer | Cyanine Dye of Formula (1) | Absence | Iodonium Salt | - | 0.3 | 4.5 | A |
| Example 2 | Coating Solution 2 for Image-forming Layer | Cyanine Dye of Formula (1) | Acid Color-forming Agent | Iodonium Salt | - | 0.3 | 5 | A |
| Example 3 | Coating Solution 3 for Image-forming Layer | Cyanine Dye of Formula (1) | Heat Color-forming Agent | Iodonium Salt | - | 0.3 | 5 | A |
| Example 4 | Coating Solution 4 for image-forming Layer | Cyanine Dye of Formula (1) | Absence | Sulfonium Salt | - | 0.3 | 4.5 | A |
| Example 5 | Coating Solution 1 for Image-forming Layer | Cyanine Dye of Formula (1) | Absence | Iodonium Salt | - | 0.3 | 4.5 | A |
| Example 6 | Coating Solution 1 for Image-forming Layer | Cyanine Dye of Formula (1) | Absence | Iodonium Salt | - | 0.31 | 5.5 | A |
| Example 7 | Coating Solution 1 for Image-forming Layer | Cyanine Dye of Formula (1) | Absence | Iodonium Salt | - | 0.32 | 5.5 | A |
| Example 8 | Coating Solution 1 for Image-forming Layer | Cyanine Dye of Formula (1) | Absence | Iodonium Salt | - | 0.27 | 6 | B |
| Example 9 | Coating Solution 1 for Image-forming Layer | Cyanine Dye of Formula (1) | Absence | Iodonium Salt | - | 0.27 | 6.5 | B |
| Example 10 | Coating Solution 2 for Image-forming Layer | Cyanine Dye of Formula (1) | Acid Color-forming Agent | Iodonium Salt | - | 0.27 | 7 | B |
| Example 11 | Coating Solution 3 for Image-forming Layer | Cyanine Dye of Formula (1) | Heat Color-forming Agent | Iodonium Salt | - | 0.27 | 7 | B |
| Example 12 | Coating Solution 3 for Image-forming Layer | Cyanine Dye of Formula (1) | Heat Color-forming Agent | Iodonium Salt | - | 0.22 | 7.5 | A |
| Example 13 | Coating Solution 1 for Image-forming Layer | Cyanine Dye of Formula (1) | Absence | Iodonium Salt | - | 0.32 | 5 | B |
| Example 14 | Coating Solution 1 for Image-forming Layer | Cyanine Dye of Formula (1) | Absence | Iodonium Salt | - | 0.27 | 5.5 | B |
| Example 15 | Coating Solution 2 for Image-forming Layer | Cyanine Dye of Formula (1) | Acid Color-forming Agent | Iodonium Salt | - | 0.27 | 6 | B |
| Example 16 | Coating Solution 3 for Image-forming Layer | Cyanine Dye of Formula (1) | Heat Color-forming Agent | Iodonium Salt | - | 0.27 | 6 | B |
| Example 17 | Coating Solution 1 for Image-forming Layer | Cyanine Dye of Formula (1) | Absence | Iodonium Salt | - | 0.27 | 5.5 | B |
| Example 18 | Coating Solution 5 for Image-forming Layer | Cyanine Dye of Formula (1) | Acid Color-forming Agent | Iodonium Salt | TPB*1 | 0.27 | 6.5 | B |
| Example 19 | Coating Solution 6 for Image-forming Layer | Cyanine Dye of Formula (1) | Heat Color-forming Agent | Iodonium Salt | TPB*1 | 0.27 | 6.5 | B |
| Example 20 | Coating Solution 3 for Image-forming Layer | Cyanine Dye of Formula (1) | Heat Color-forming Agent | Iodonium Salt | - | 0.17 | 8 | A |
| Comparative Example 1 | Coating Solution 1 for Image-forming Layer | Cyanine Dye of Formula (1) | Absence | Iodonium Salt | - | 0.48 | 3.5 | B |
| Comparative Example 2 | Coating Solution 2 for Image-forming Layer | Cyanine Dye of Formula (1) | Acid Color-forming Agent | Iodonium Salt | - | 0.48 | 4 | B |
| Comparative Example 3 | Coating Solution 3 for image-forming Layer | Cyanine Dye of Formula (1) | Heat Color-forming Agent | Iodonium Salt | - | 0.48 | 4 | B |
| Comparative Example 4 | Coating Solution 7 for Image-forming Layer | Cyanine Dye of Formula (1) | Absence | Iodonium Salt | Compound 1 | 0.48 | 3.5 | A |
| Comparative Example 5 | Coating Solution 8 for Image-forming Layer | Cyanine Dye of Formula (1) | Absence | Iodonium Salt | MB*2 | 0.55 | 2 | A |

| | | | | | | | | |
|---|---|---|---|---|---|---|---|---|
| *1: Sodium tetraphenylborate *2: Methylene blue | | | | | | | | |

### INDUSTRIAL APPLICABILITY

According to the invention, a lithographic printing plate precursor capable of undergoing on-press development which is excellent in visibility of visible image after exposure and a printing method thereof can be provided.

Although the invention has been described in detail and by reference to specific embodiments, it is apparent to those skilled in the art that it is possible to add various alterations and modifications insofar as the alterations and modifications do not deviate from the scope of the invention, which is defined by the appended claims. This application is based on a Japanese patent application filed on March 29, 2012 (Japanese Patent Application No. 2012-078095).

## Claims

1. A lithographic printing plate precursor having at least a white substrate and an image-recording layer,
wherein the white substrate is an aluminum support which is subjected to a roughening treatment and an anodizing treatment so as to have a steepness degree a45 of 30% or less, wherein a45 represents an area ratio of a portion having an inclination of 45° or more obtained by extracting components having a wavelength from 0.2 to 2 µm,
the white substrate has a reflection density of 0.25 or less at a side having the image-recording layer, and
the image-recording layer contains an infrared absorbing agent, an onium salt polymerization initiator, a polymerizable compound and a color-forming compound and is capable of being removed with at least any one of printing ink and dampening water.

2. A lithographic printing plate precursor according to claim 1, wherein the color-forming compound is a cyanine dye represented by the following formula (1): 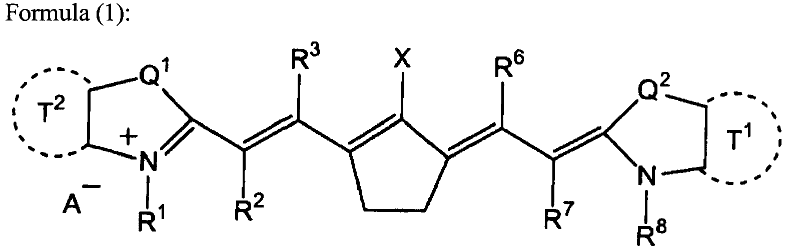 wherein R¹ and R⁸ each independently represents a monovalent substituent, R², R³, R⁶ and R⁷ each independently represents a hydrogen atom or a hydrocarbon group, X represents -NPh₂, Q¹ and Q² each independently represents -NR⁹-, a sulfur atom, an oxygen atom or a dialkylmethylene group, R⁹ represents a hydrogen atom or a hydrocarbon group which may have a substituent, T¹ and T² each independently represents an aromatic ring or a heteroaromatic ring, and A⁻ represents an anion.

3. A lithographic printing plate precursor acording to claim 1 or to claim 2, wherein the onium salt polymerization initiator is an iodonium salt or a sulfonium salt.

4. A lithographic printing plate precursor according to any of claims 1-3, wherein the color-forming compound is an acid color-forming agent.

5. The lithographic printing plate precursor as claimed in Claims 1 to 4, wherein the image-recording layer contains a borate compound.

6. The lithographic printing plate precursor as claimed in Claims 1 to 5, wherein the borate compound is a tetraphenyl borate.

7. A printing method of a lithographic printing plate comprising exposing imagewise the lithographic printing plate precursor as claimed in any one of Claims 1 to 6 with an infrared laser, mounting the exposed lithographic printing plate precursor on a printing machine, and removing an unexposed area of the image-recording layer by supplying printing ink and dampening water to perform printing.

## Patentansprüche

1. Lithographischer Druckplattenvorläufer, der mindestens ein weißes Substrat und eine Bildaufzeichnungsschicht aufweist,
worin das weiße Substrat ein Aluminiumträger ist, der einer Aufrauhbehandlung und einer Anodisierungsbehandlung unterzogen wird, so dass es einen Steilheitsgrad a45 von 30% oder weniger aufweist, wobei a45 einen Flächenanteil eines Bereiches mit einer Neigung von 45° oder mehr darstellt, der durch Extrahieren von Bestandteilen mit einer Wellenlänge von 0,2 bis 2 µm erhalten wird,
das weiße Substrat an einer Seite, die die Bildaufzeichnungsschicht aufweist, eine Reflexionsdichte von 0,25 oder weniger aufweist und
die Bildaufzeichnungsschicht ein Infrarotabsorptionsmittel, einen Oniumsalz-Polymerisationsinitiator, eine polymerisierbare Verbindung und eine farbbildende Verbindung enthält und mit mindestens einem aus Druckfarbe und Feuchtwasser entfernt werden kann.

2. Lithographischer Druckplattenvorläufer gemäß Anspruch 1, worin die farbbildende Verbindung ein Cyaninfarbstoff ist, der durch die folgende Formel (1) dargestellt wird: 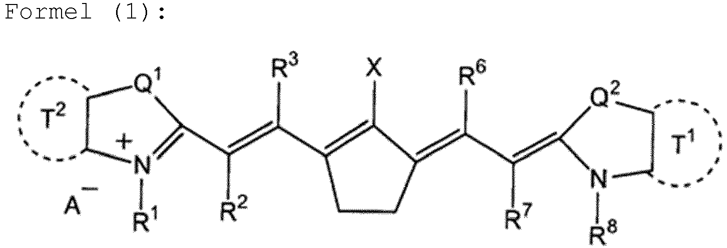 worin R¹ und R⁸ jeweils unabhängig einen einwertigen Substituenten darstellt, R², R³, R⁶ und R⁷ jeweils unabhängig ein Wasserstoffatom oder eine Kohlenwasserstoffgruppe darstellt, X -NPh₂ darstellt, Q¹ und Q² jeweils unabhängig - NR⁹-, ein Schwefelatom, ein Sauerstoffatom oder eine Dialkylmethylengruppe darstellt, R⁹ ein Wasserstoffatom oder eine Kohlenwasserstoffgruppe darstellt, die einen Substituenten aufweisen kann, T¹ und T² jeweils unabhängig einen aromatischen Ring oder einen heteroaromatischen Ring darstellt und A⁻ ein Anion darstellt.

3. Lithographischer Druckplattenvorläufer gemäß Anspruch 1 oder 2, worin der Oniumsalz-Polymerisationsinitiator ein Iodoniumsalz oder ein Sulfoniumsalz ist.

4. Lithographischer Druckplattenvorläufer gemäß mindestens einem der Ansprüche 1-3, worin die farbbildende Verbindung ein Säurefarbbildungsmittel ist.

5. Lithographischer Druckplattenvorläufer gemäß mindestens einem der Ansprüche 1-4, worin die Bildaufzeichnungsschicht eine Boratverbindung enthält.

6. Lithographischer Druckplattenvorläufer gemäß mindestens einem der Ansprüche 1-5, worin die Boratverbindung Tetraphenylborat ist.

7. Druckverfahren für eine lithographische Druckplatte, umfassend das bildweise Belichten des lithographischen Druckplattenvorläufers wie in mindestens einem der Ansprüche 1 bis 6 beansprucht mit einem Infrarotlaser, das Montieren des belichteten lithographischen Druckplattenvorläufers auf eine Druckmaschine und das Entfernen eines unbelichteten Bereichs der Bildaufzeichnungsschicht durch Zuführen von Druckfarbe und Feuchtwasser zum Ausführen des Drucks.

## Revendications

1. Précurseur de plaque d'impression lithographique ayant au moins un substrat blanc et une couche d'enregistrement d'image,
dans lequel le substrat blanc est un support d'aluminium qui est soumis à un traitement de rugosification et à un traitement d'anodisation afin d'avoir un degré de variation de pente a45 de 30% ou moins, dans lequel a45 représente un rapport surfacique d'une portion ayant une inclinaison de 45° ou plus obtenue en extrayant des composants ayant une longueur d'onde de 0,2 à 2 µm,
le substrat blanc a une densité de réflexion de 0,25 ou moins au niveau d'un côté ayant la couche d'enregistrement d'image, et
la couche d'enregistrement d'image contient un agent absorbant l'infrarouge, un initiateur de polymérisation au sel d'onium, un composé pouvant être polymérisé et un composé de formation de couleur et est susceptible d'être enlevé avec au moins n'importe laquelle d'une encre d'impression et d'une eau de mouillage.

2. Précurseur de plaque d'impression lithographique selon la revendication 1,
dans lequel le composé de formation de couleur est un colorant cyanine représenté par la formule (1) suivante : 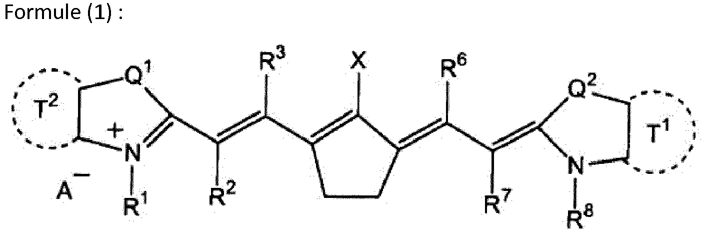 dans laquelle R¹ et R⁸ représentent chacun indépendamment un substituant monovalent, R², R³, R⁶ et R⁷ représentent chacun indépendamment un atome d'hydrogène ou un groupe hydrocarbure, X représente -NPh₂, Q¹ et Q² représentent chacun indépendamment -NR⁹-, un atome de soufre, un atome d'oxygène ou un groupe dialkylméthylène, R⁹ représente un atome d'hydrogène ou un groupe hydrocarbure qui peut avoir un substituant, T¹ et T² représentent chacun indépendamment un cycle aromatique ou un cycle hétéroaromatique, et A⁻ représente un anion.

3. Précurseur de plaque d'impression lithographique selon la revendication 1 ou la revendication 2,
dans lequel l'initiateur de polymérisation au sel d'onium est un sel d'iodonium ou un sel de sulfonium.

4. Précurseur de plaque d'impression lithographique selon l'une quelconque des revendications 1 à 3, dans lequel le composé de formation de couleur est un agent de formation de couleur acide.

5. Précurseur de plaque d'impression lithographique selon les revendications 1 à 4, dans lequel la couche d'enregistrement d'image contient un composé de borate.

6. Précurseur de plaque d'impression lithographique selon les revendications 1 à 5, dans lequel le composé de borate est un borate de tétraphényle.

7. Procédé d'impression d'une plaque d'impression lithographique comprenant l'exposition suivant une image du précurseur de plaque d'impression lithographique selon l'une quelconque des revendications 1 à 6 avec un laser infrarouge, le montage du précurseur de plaque d'impression lithographique exposé sur une machine d'impression, et l'enlèvement d'une surface non exposée de la couche d'enregistrement d'image en fournissant de l'encre l'impression et de l'eau de mouillage pour effectuer l'impression.
